# EUROPEAN PATENT SPECIFICATION

(11) **EP 1 331 282 B1**
(45) Date of publication and mention of the grant of the patent: **19.11.2008**
(21) Application number: 03250281.7
(22) Date of filing: 16.01.2003
(51) Int. Cl.: C23C 14/20, C23C 14/02, C23C 14/34, C23C 30/00, C23C 14/16

(54) **Method for making decorative articles**
Verfahren zur Herstellung dekorativer Gegenstände
Procédé pour la fabrication d'articles décoratifs

(30) Priority: 16.01.2002 JP 2002008062; 29.08.2002 JP 2002252137
(43) Date of publication of application: 30.07.2003
(73) Proprietor: Seiko Epson Corporation, Shinjuku-ku Tokyo 163-0811 (JP)
(72) Inventor: Kawakami, Atsushi, c/o Seiko Epson Corporation, Suwa-shi, Nagano-ken 392-8502 (JP); Obi, Yoshiyuki, c/o Seiko Epson Corporation, Suwa-shi, Nagano-ken 392-8502 (JP); Tsukamoto, Yuzuru, c/o Seiko Epson Corporation, Suwa-shi, Nagano-ken 392-8502 (JP)
(74) Representative: Sturt, Clifford Mark

(56) References cited:
- EP-A- 0 611 833
- EP-A- 0 798 401
- US-A- 4 326 889
- US-A- 4 791 017
- PATENT ABSTRACTS OF JAPAN vol. 2002, no. 02, 2 April 2002 (2002-04-02) & JP 2001 294955 A (SEIKO INSTRUMENTS INC;SEIKO EPSON CORP), 26 October 2001 (2001-10-26)

## Description

The present invention relates to a surface processing method for decorative articles, a decorative article, and a timepiece.

An attractive, aesthetically appealing appearance is needed in decorative articles such as used for the outside case of a watch. Conventionally this has been achieved by using Au or other gold-colored metal, or a silver-colored metal such as Pd, Rh, or Pt, to make the decorative parts.

A greater variety of colors has become desirable for these decorative parts in recent years, and materials with an attractive, colorful appearance that cannot be achieved with the above-noted materials are in demand.

For example, Au-Fe alloys are used to achieve decorative parts with a whitish gold color. Au-Fe alloys, however, lack a sense of high quality, and it is difficult to achieve decorative parts with a relatively strong white tone such as the color 1N-14 defined by CEN standard EN 28654 using a Au-Fe alloy. Au-Fe alloys also suffer from relatively poor oxidation resistance due to Fe oxidation, and thus over a long period of time tend to not keep a stable appearance and color tone.

Also, colors close to color 1N-14 defined by CEN standard EN 28654 can be achieved with Au-Ag-Cu alloys, but these alloys are particularly susceptible to color change over time and use with decorative parts is thus difficult.

An object of the present invention is therefore to provide a decorative article with a whitish gold color that can retain an exceptionally beautiful appearance over a long period of time.

A further object is to provide a surface processing method enabling the manufacture of such decorative articles.

A yet further object is to provide a timepiece using such decorative articles.

These objects are achieved by the present invention as noted in (1) to (25) below, while items (26) to (36) are further preferable.
(1) A surface processing method for a decorative article, characterized by having a step for forming a film composed of a Au-Pd-Fe-In alloy containing 0.1 to 10 wt% Pd, 0.1 to 8 wt% Fe, 0.1 to 10.0 wt% In, and optionally a total content of 1.5 wt% or less of one or more of Cu, Zn, Ni, Mg, Cr, Mn, Mo, Nb, W, Al, Ag, V, Zr, Sn and Pt, the balance of the alloy being made up of Au, wherein the film is formed by a dry plating method on at least part of a base material surface.
(2) A surface processing method for a decorative article as noted in (1) above, having a further step for applying a cleaning process to at least part of the base material surface before the film forming step.
(3) A surface processing method for a decorative article, characterized by having a step for forming at least one primary coat on at least part of a base material surface, and a step for forming on this primary coat by a dry plating method a film composed of a Au-Pd-Fe-In alloy containing 0.1 to 10 wt% Pd, 0.1 to 8 wt% Fe, 0.1 to 10.0 wt% In, and optionally a total content of 1.5 wt% or less of one or more of Cu, Zn, Ni, Mg, Cr, Mn, Mo, Nb, W, Al, Ag, V, Zr, Sn and Pt, the balance of the alloy being made up of Au.
(4) A surface processing method for a decorative article as described in (3) above, having a further step for applying a cleaning process to at least part of the base material surface before the step forming the primary coat.
(5) A surface processing method for a decorative article as described in (3) or (4) above, having a further step for applying a cleaning process to at least part of the primary coat surface before the film forming process.
(6) A surface processing method for a decorative article as described in any of (3) to (5) above, wherein at least one of the primary coats is a buffer layer for buffering the potential difference between one surface side thereof and the other surface side.
(7) A surface processing method for a decorative article as described in any of (3) to (6) above, wherein at least one primary coat is a metal nitride layer composed of a material containing a nitride of at least one of the following: Ti, Zr, Hf, Ta, Cr.
(8) A surface processing method for a decorative article as described in (7) above, wherein the metal nitride layer contacts the above-noted film.
(9) A surface processing method for a decorative article as described in any of (3) to (8) above, wherein at least one primary coat is a metal layer of or an alloy composed of at least one of the following: Cu, Co, Pd, Au, Ag, In, Sn, Ni, Ti, Zn, Al, Fe, Cr, Pt, Rh, Ru, Ir.
(10) A surface processing method for a decorative article as described in any of (3) to (9) above, wherein the decorative article has two or more primary coats.
(11) A surface processing method for a decorative article as described in (1) above, wherein adjacent primary coats are composed of materials containing a common element.
(12) A surface processing method for a decorative article as described in any of (1) to (11) above, wherein the film is formed by a vacuum deposition method.
(13) A surface processing method for a decorative article as described in (12) above, wherein the film is formed by a dry plating method using plural targets of different metal compositions.
(14) A surface processing method for a decorative article as described in (13) above, wherein a Au-Pd-Fe alloy target and an In target are used as the targets.
(15) A surface processing method for a decorative article as described in any of (1) to (14) above, wherein the film has a color close to color 1N-14 as defined in CEN standard EN 28654.
(16) A surface processing method for a decorative article as described in any of (1) to (15) above, also having a step for masking at least part of the film surface after forming the film, a step for removing the film in parts not covered by the mask using a stripping agent, and a step for removing the mask.
(17) A decorative article characterized by being manufactured using a surface processing method for a decorative article as described in any of (1) to (16) above.
(18) A decorative article having a base material and a film covering at least part of the base material, characterized by the film being composed of a Au-Pd-Fe-In alloy containing 0.1 to 10 wt% Pd, 0.1 to 8 wt% Fe, 0.1 to 10.0 wt% In, and optionally a total content of 1,5 wt% or less of one or more of Cu, Zn, Ni, Mg, Cr, Mn, Mo, Nb, W, Al, Ag, V, Zr, Sn and Pt, the balance of the alloy being made up of Au.
(19) A decorative article as described in (18) above, further having at least one primary coat between the base material and film.
(20) A decorative article as described in (19) above, wherein at least one primary coat is a buffer layer for buffering the potential difference between one surface side thereof and the other surface side.
(21) A decorative article as described in (19) or (20) above, wherein at least one primary coat is a metal nitride layer composed of a material containing a nitride of at least one of the following: Ti, Zr, Hf, Ta, Cr.
(22) A decorative article as described in any of (19) to (21) above, wherein at least one primary coat is a metal layer or an alloy composed of at least one of the following: Cu, Co, Pd, Au, Ag, In, Sn, Ni, Ti, Zn, Al, Fe, Cr, Pt, Rh, Ru, Ir.
(23) A decorative article as described in any of (19) to (22) above, wherein the film has a color close to color 1N-14 as defined in CEN standard EN 28654.
(24) A decorative article as described in any of (17) to (23) above, wherein the decorative article is a case part for a timepiece.
(25) A timepiece characterized by having a decorative article as described in any of (17) to (24) above.
(26) A surface processing method for a decorative article as described in (7) or (8) above, wherein the average thickness of the metal nitride layer is 0.01 to 10 µm.
(27) A surface processing method for a decorative article as described in (9) above, wherein the average thickness of the metal layer is 0.05 to 50 µm.
(28) A surface processing method for a decorative article as described in (11) above, wherein the common element is Cu.
(29) A surface processing method for a decorative article as described in any of (1) to (16) above, wherein the average film thickness is 0.01 to 10 µm.
(30) A surface processing method for a decorative article as described in (16) above, wherein the average mask thickness is 100 to 2000 µm.
(31) A surface processing method for a decorative article as described in any of (1) to (16) above, wherein the base material is or is an alloy of at least one of the following: Cu, Zn, Ni, Ti, Al, Mg.
(32) A surface processing method for a decorative article as described in any of (1) to (16) above, wherein the base material is composed of primarily stainless steel.
(33) A surface processing method for a decorative article as described in any of (1) to (16) above, wherein the base material is manufactured by casting or metal powder injection molding.
(34) A surface processing method for a decorative article as described in any of (1) to (16) above, wherein the base material has one of the following surface processing methods applied to at least part of the surface thereof: planishing, brushing satinizing.
(35) A decorative article as described in any of (18) to (24) above, wherein the average film thickness is 0.01 to 10 µm.
(36) A decorative article as described in any of (17) to (24) above, wherein at least part thereof is used in contact with the skin.

Embodiments of the present invention will now be described by way of further example only and with reference to the accompanying drawings, in which:-
Fig. 1 is a section view showing a first embodiment of a surface processing method according to the present invention.
Fig. 2 is a section view showing a second embodiment of a surface processing method according to the present invention.
Fig. 3 is a section view showing a third embodiment of a surface processing method according to the present invention.
Fig. 4 is a section view showing a fourth embodiment of a surface processing method according to the present invention.
Fig. 5 is a section view showing a fifth embodiment of a surface processing method according to the present invention.
Fig. 6 is a color chart showing the color of the film on the decorative articles obtained by each embodiment.

### [Key to the figures]

- 1A, 1B, 1C, 1D, 1E: decorative article
- 2: base material
- 3: film
- 40: primary coat
- 41a: first primary coat
- 41b: first primary coat
- 42a: second primary coat
- 42b: second primary coat
- 43b: third primary coat
- 5: mask

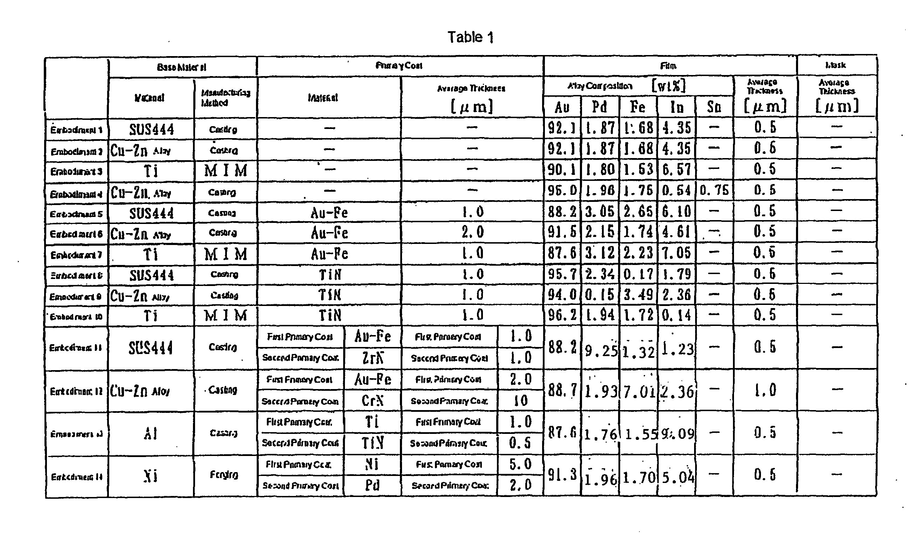

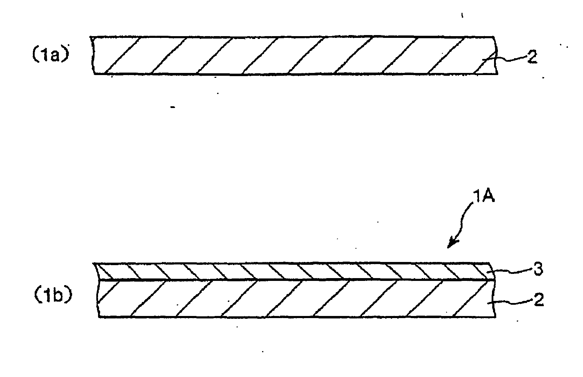

Fig. 1 is a section view showing a first embodiment of a surface processing method according to the present invention.

As shown in Fig. 1, the surface processing method according to this embodiment of the invention has a step (1b) for forming a film 3 composed of a Au-Pd-Fe-In alloy on at least part of the surface of base material 2 (1a) using a dry plating method.

### * Base material 2]

The base material 2 can be made of any desired material, including metallic and non-metallic materials.

When the base material 2 is metal a decorative article 1A with an excellent strength characteristic can be provided.

If the base material 2 is made of metal and the surface roughness of the base material 2 is relatively high, the levelling effect of forming film 3 described below can reduce the surface roughness of the resulting decorative article 1A. For example, even if mechanical processing such as cutting or polishing the surface of base material 2 is not used, a mirror finish can still be achieved. A mirror surface can even be easily achieved when the base material 2 is formed using a metal injection molding (MIM) method and the surface has a satin finish. A decorative article with excellent luster can thus be achieved.

If the base material 2 is a non-metallic material, a decorative article 1A that is relatively light and portable and has a substantial appearance can be provided.

When the base material 2 is a non-metallic material it can also be processed relatively easily to a desired shape. This makes it possible to manufacture relatively easily a decorative article 1A with a shape that is difficult to mold directly.

Furthermore, an electromagnetic noise shielding effect can also be achieved when the base material 2 is a non-metallic material.

Metal materials that can be used for the base material 2 include metals such as Fe, Cu, Zn, Ni, Mg, Cr, Mn, Mo, Nb, Al, V, Zr, Sn, Au, Pd, Pt, and Ag, and alloys containing at least one of these. In particular, by using Cu, Zn, Ni, Ti, Al, Mg or an alloy containing at least one of these, particularly good adhesion can be achieved between the base material 2 and film 3 further described below.

Yet further, by using Cu, Zn, Ni or an alloy containing at least one of these for the base material 2, even better adhesion can be achieved between the base material 2 and film 3 further described below, the processing characteristics of base material 2 are improved, and there is even greater freedom in molding the base material 2.

If the base material 2 is made primarily from stainless steel, adhesion between the base material 2 and film 3 will be particularly outstanding, the processing characteristics of base material 2 will be improved, and there is even greater freedom in shaping the base material 2. Exemplary stainless steel materials include Fe-Cr alloys and Fe-Cr-Ni alloys. Examples of Fe-Cr-Ni alloys include SUS 304, SUS 303, SUS 316, SUS 316L, SUS 316J1, AND SUS 316J1L. Examples of Fe-Cr alloys include SUS 405, SUS 430, SUS 434, SUS 444, SUS 429, and SUS 430F.

If the base material 2 is a non-metallic material it could be plastic, ceramic, stone, wood, or glass, for example.

Exemplary plastic materials include thermoplastic resins and thermosetting resins. If the base material 2 is plastic a decorative article 1A that is relatively light and portable while having a substantial appearance can be achieved.

A plastic base material 2 can also be molded relatively easily to a desired shape. This makes it possible to manufacture relatively easily a decorative article 1A with a complicated shape.

Furthermore, an electromagnetic noise shielding effect can also be achieved when the base material 2 is made of plastic.

Exemplary ceramic materials include, for example, oxide ceramics such as Al₂O₃, SiO₂, TiO₂, ZrO₂, Y₂O₃, barium titanate, and strontium titanate; nitride ceramics such as AlN, Si₃N₄, SiN, TiN, BN, ZrN, HfN, VN, TaN, NbN, CrN, and Cr₂N; graphite and carbide ceramics such as SiC, ZrC, Al₄C₃, CaC₂, WC, TiC, HfC, VC, TaC, and NbC; boride ceramics such as ZrB₂ and MoB; and compound ceramics combining any two or more such ceramics.

When the base material 2 is made from such a ceramic, a decorative article 1A with high strength and high hardness can be achieved.

The base material 2 can be manufactured in various ways and the present invention shall not be limited to any particular method.

Exemplary methods that can be used when the base material 2 is made from a metal material include pressing, cutting, forging, casting, powder metallurgy annealing, metal powder injection molding (MIM), and lost wax casting. Of these casting and metal powder injection molding (MIM) are particularly desirable. Casting and metal powder injection molding (MIM) in particular offer excellent processing characteristics. A base material 2 with a complex shape can therefore be manufactured relatively easily using these methods.

A typical metal powder injection molding (MIM) process is described below.

First, a material containing metal powder and an organic binder are mixed and kneaded to produce a kneaded mixture. A molding is then made by injection molding this kneaded mixture. A degreasing process (debindering process) is then applied to this molding to obtain a degreased molding. This degreasing process is typically done by heating the molding under vacuum conditions. The cleaned molding is then sintered to get a sintered body. This sintering process is usually at a higher temperature than the degreasing process. The sintered body resulting from this process can be used as the base material of the present invention.

If the base material 2 is made from one of the above plastic materials it can be manufactured by such methods as compression molding, extrusion molding, injection molding, and shape deposition manufacturing.

If the base material 2 is made from one of the above ceramic materials the invention shall not be particularly limited to any particular manufacturing technique, but metal injection molding (MIM) is preferable. Metal powder injection molding (MIM) in particular offers excellent processing characteristics, and a base material 2 with a complex shape can therefore be manufactured relatively easily.

The surface of base material 2 is preferably processed by planishing, embossing, or satinizing. These processes make it possible to vary the luster of the decorative article 1A surface, and can further improve the decorativeness of the resulting decorative article 1A. Furthermore, the film 3 on a decorative article 1A manufactured using a base material 2 that has been thus surface processed can be made to be less glittery compared with applying the surface processing directly to the film 3, and can thus be made more aesthetically pleasing.

The base material 2 can also be pretreated before forming the film 3 as described below in order to improve adhesion between the base material 2 and film 3. Pretreatment processes include cleaning by blasting, alkaline cleaning, acid cleaning, water washing, organic solvent cleaning, and bombardment cleaning, or etching, but a cleaning process is preferable. Particularly good adhesion between the base material 2 and film 3 can be achieved by cleaning the surface of the base material 2 before forming the film 3.

### * Formation of film 3]

The present invention is characterized by forming the base material 2 from a Au-Pd-Fe-In alloy containing 0.1 to 10 wt% Pd, 0.1 to 8 wt% Fe, and 0.1 to 10.0 wt% In.

A decorative article 1A with an extremely aesthetically pleasing whitish gold appearance can be achieved by forming the film 3 from a material with this composition.

The decorative article 1A also has sufficient corrosion resistance by forming the film 3 from a material with this composition.

Furthermore, if the content (content ratio) of these elements in the Au-Pd-Fe-In alloy is outside these ranges, it is difficult to achieve a decorative article 1A with a whitish gold color.

Furthermore, by using a film 3 with this composition gold colored decorative articles with a relatively strong white tone that is difficult to achieve with conventional Au-Fe alloys can be easily manufactured.

Furthermore, Au and In rarely cause an allergic reaction. The present invention can therefore be used in decorative articles, such as watches, that are worn in contact with the skin.

The Pd content (content ratio) in film 3 is 0.1 to 10 wt%. If the Pd content is less than 0.1 wt%, the resulting film 3 will have low hardness and poor corrosion resistance. If the Pd content is above 10 wt%, the internal stress of film 3 will increase and cracks will form easily.

The Fe content (content ratio) in film 3 is 0.1 to 8 wt%. If Fe content is less than 0.1 wt%, the resulting film 3 will have a low strength characteristic. If Fe exceeds 8 wt%, sufficient corrosion resistance will not be achieved.

The In content (content ratio) in film 3 is 0.1 to 10.0 wt%. If In content is less than 0.1 wt% the resulting film 3 will have a low strength characteristic. If In exceeds 10.0 wt%, the internal stress of film 3 will increase and cracks will form easily.

As noted above the Pd content (content ratio) in film 3 is 0.1 to 10 wt%, but is preferably 0.5 to 7 wt%, and is further preferably 1 to 3 wt%. If Pd content is within these ranges film 3 will have particularly good corrosion resistance and low internal stress.

Furthermore, the Fe content (content ratio) in film 3 is 0.1 to 8 wt%, but is preferably 0.1 to 5 wt%, and yet further preferably 1 to film 3 wt%. If Fe content is within these ranges film 3 will have particularly good corrosion resistance and low internal stress.

Furthermore, the In content (content ratio) in film 3 is 0.1 to 10.0 wt%, but is preferably 1 to 7 wt% and yet further preferably film 3 to 5 wt%. If In content is within these ranges film 3 will have particularly good corrosion resistance and low internal stress.

The alloy used to form film 3 can contain elements other than Au, Pd, Fe, and In (which are referred to below as the required elements). Other elements that could be used include Cu, Zn, Ni, Mg, Cr, Mn, Mo, Nb, W, Al, Ag, V, Zr, Sn, and Pt. Furthermore, any one or two or more of these additional elements can be used. If elements other than the required elements are included, Sn is particularly desirable. Furthermore, if elements other than the required elements are included, the content of the other elements (the total content of the other elements if two or more other elements arc also used) is less than or equal to 1.5 wt%, and preferably less than or equal to 1.0 wt%.

The present invention is further characterized by forming film 3 using a dry plating method (gas phase film formation method).

By forming the film 3 with a dry plating method a film 3 with excellent adhesion to the base material 2 can be achieved. As a result, the resulting decorative article 1A offers excellent corrosion resistance and durability. Furthermore, by using a dry plating method a film 3 with high density can be achieved. As a result, film 3 offers high luster and a particularly beautiful appearance.

Furthermore, by using a dry plating method a uniform film thickness can be achieved even when the thickness of film 3 is relatively thin. The present invention can therefore be suitably applied to small decorative articles (for example, external parts for timepieces and internal parts for timepieces).

Furthermore, by using a dry plating method the film 3 can be formed easily and dependably even when film 3 has a complex composition containing an element other than the required elements.

Exemplary dry plating methods include vacuum deposition, sputtering, thermal CVD, plasma CVD, laser CVD, and other chemical vapor deposition (CVD) methods, ion plating, and ion injection, but of these vacuum deposition is preferable. By using vacuum deposition as the dry plating method, a uniform film 3 with particularly excellent adhesion to the base material 2 can be achieved relatively easily with relatively simple equipment. As a result, the durability of the resulting decorative article 1A can be further improved. Furthermore, a particularly high density film 3 can be achieved by using vacuum deposition. As a result, the decorative article 1A can retain a particularly beautiful appearance for a long time.

Vacuum deposition is preferably conducted under the following conditions.

The deposition materials can be heated using such methods as a heat transfer crucible, electron beam, high frequency, or laser, or resistance heating, but of these resistance heating is preferable. By using resistance heating as the heating method of the deposition materials a uniform film 3 can be achieved with a simple method.

The gas of the vacuum deposition atmosphere is preferably an inert gas (such as He gas, Ne gas, Ar gas, or N₂ gas) . The gas pressure for vacuum deposition is not particularly limited, but is preferably in the range of 1.0 x 10⁻⁶ to 1.0 x 10⁻⁵ Torr, and is further preferably in the range of 3.0 x 10⁻⁶ to 1.0 x 10⁻⁶ Torr.

Furthermore, dry plating is preferably conducted using plural targets of different metal compositions. By thus using plural targets of different metal compositions each target can be heated separately, for example, and vaporation of each target can be adjusted. As a result, a film 3 with a desired composition can be easily formed. By thus adjusting the composition of film 3, the characteristics (such as color, luster, and hardness) of film 3 can be adjusted.

When plural targets are used the targets are preferably a Au-Pd-Fe alloy target and an In target. This makes it possible to easily adjust the In content of the formed film 3. As a result the whiteness of the film 3 color, for example, can be easily adjusted.

The average thickness of the film 3 formed by a dry plating method shall not be specifically limited, but is preferably in the range of 0.01 to 10 µm, and is further preferably 0.1 to film 3 µm. If the average thickness of the film 3 is less than the above lower limit, pinholes form easily in the film 3 and the effect of the present invention may not be fully exhibited. In addition, if the average thickness of the film 3 is above the above upper limit, internal stress in the film 3 increases, adhesion between the film 3 and base material 2 decreases, and cracks occur easily.

Furthermore, by forming the film 3 from the above alloy compositions, excellent surface lubricity can be easily achieved. It is therefore possible to reduce and prevent a coarse surface texture, and an unnatural, discomforting feeling when the decorative article 1A contacts the skin can be reduced and prevented.

With the present invention as described above a whitish gold decorative article 1A can be achieved.

The color of the film 3 shall not be specifically limited, but is preferably a color close to color 1N-14 defined by CEN (Comite Europeen de Normalisation) standard EN 28654. If the color of film 3 is close to color 1N-14, decorative article 1A has a particularly attractive appearance and a further sense of high quality. It should be noted that a "color close to color 1N-14" can, for example, be defined on the L*a*b* color chart defined in JIS Z8729 as a color in the range where a* is from - 3.0 to 2.0 and b* is in the range 19 to 25.

It should be noted that the composition in each part of film 3 could be constant or not constant. For example, the composition of film 3 could be one (a gradient material) that changes gradually through the thickness direction thereof.

Furthermore, film 3 could be a laminate of plural layers of different compositions.

Furthermore, in the configuration shown in the figure film 3 is shown covering the entire surface of the base material 2, but could be formed to only part of the surface of base material 2.

A decorative article 1A can be achieved by the surface processing method described above.

The decorative article 1A can be any kind of decorative product such as decorative figurines and other interior design goods, exterior design goods, jewelry, watch cases (including the body and back cover), watch bands, dials, watch hands and other external timepiece parts, base plate of the movement, gears and gear train bearings, rotary pendulum and other internal timepiece parts, eyeglasses, necktie pins, cuff links, rings, necklaces, bracelets, anklets, broaches, pendants, earrings, pierced earrings, and other personal adornments, lighters and lighter cases, golf clubs and other sporting gods, name plates, panels, trophy cups, mechanical parts including housings, and various types of containers. Of these, products of which at least part is used in contact with the skin are preferable, and external components for timepieces are particularly preferable. External parts for timepieces require a beautiful appearance as decorative articles while also being practical components requiring durability, corrosion resistance, wear resistance, and a particularly pleasing texture, and all of these conditions can be met using the surface processing method of the present invention.

A timepiece according to the present invention has a decorative article according to the present invention as described above. As described above a decorative article according to the present invention has a beautiful color and appearance and excellent corrosion resistance. A timepiece according to the present invention having this type of decorative article can therefore sufficiently satisfy the conditions required for a watch. A timepiece according to the present invention can thus retain a particularly attractive appearance for a long time. Furthermore, because it is resistant to color change, an easily recognizable color can be retained for a long time.

A further characteristic of the present invention is that the above-described effects can be achieved without requiring a special airtight construction. It should be noted that other known parts can be used as parts other than these decorative articles constructing a watch according to the present invention.

A second embodiment of a surface processing method, decorative article and timepiece according to the present invention is described next.

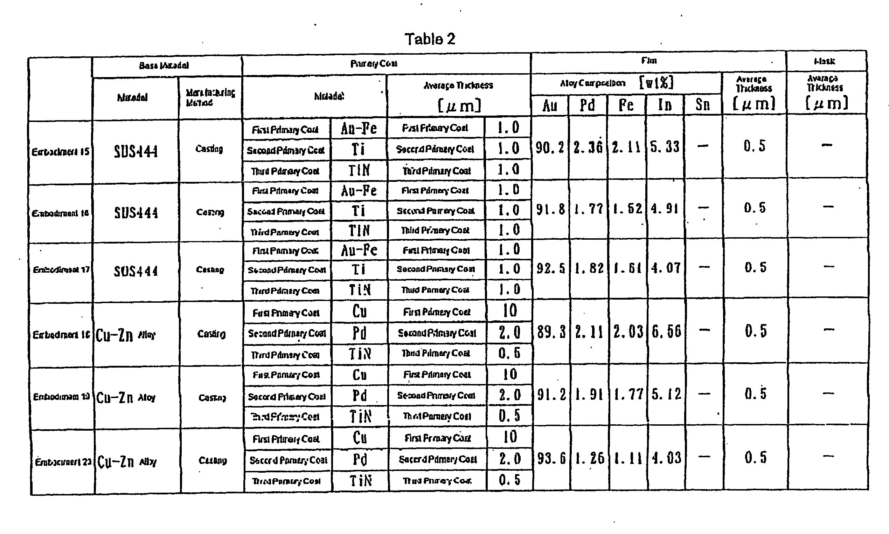

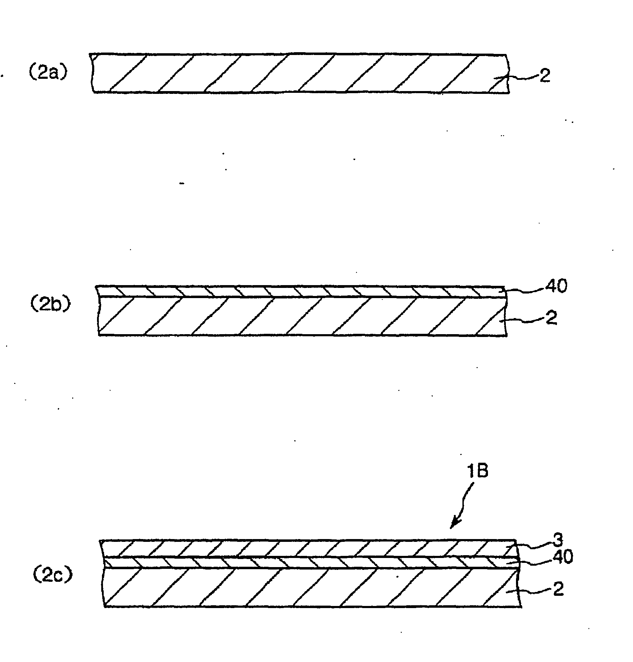

Fig. 2 is a section view showing a second embodiment of a surface processing method according to the present invention.

It should be noted that the surface processing method of this second embodiment and a decorative article according to this second embodiment manufactured using this method are described below focusing on the differences with the above first embodiment, and further description of the same items is omitted below.

As shown in Fig. 2 the surface processing method according to this embodiment of the invention has a step (2b) for forming a primary coat 40 on at least part (2a) of the surface of base material 2, and a step (2c) for forming a film 3 composed of a Au-Pd-Fe-In alloy on at least part of the surface of primary coat 40 using a dry plating method.

In other words, except for forming primary coat 40 on at least part of the surface of base material 2 before forming film 3, this embodiment is the same as the first embodiment described above.

The primary coat 40 is described below.

### * Primary coat 40]

The primary coat 40 can be formed for any desired purpose, but preferably has the following functions.

This primary coat 40 preferably functions as a buffer layer for buffering the potential difference between base material 2 and film 3, for example. As a result, corrosion (contact corrosion between metals of different types) due to the potential difference between base material 2 and film 3 can be effectively prevented.

Furthermore, primary coat 40 preferably has high hardness. This makes it possible to achieve a decorative article 1B with high hardness, and as a result the decorative article 1B features excellent durability. Vickers hardness Hv, for example, can be used as a hardness index. The Vickers hardness Hv of primary coat 40 is preferably greater than or equal to 100, further preferably greater than or equal to 150, and yet further preferably greater than or equal to 1700. If the Vickers hardness Hv of primary coat 40 is such a level, the above-described effects are even more pronounced.

Furthermore, primary coat 40 preferably functions to improve adhesion between base material 2 and film 3, for example. By thus improving adhesion between base material 2 and film 3, the corrosion resistance of decorative article 1B can be even further improved. As a result, decorative article 1B has particularly excellent durability.

In addition, primary coat 40 could also function to repair holes and scratches, for example, in base material 2 by a levelling effect.

The primary coat 40 can be formed by, for example, wet plating methods such as electrolytic plating, immersion plating, or electroless plating, vacuum deposition, sputtering, thermal CVD, plasma CVD, laser CVD and other chemical vapor deposition (CVD) methods, ion plating or other dry plating method, flame coating, or metal foil bonding, but of these a wet plating method or dry plating method is preferable. By using a wet plating method or dry plating method as the primary coat 40 formation method the resulting primary coat 40 has particularly good adhesion with the base material 2. As a result, the long-term durability of the resulting decorative article 1B is particularly excellent.

Furthermore, the primary coat 40 can be a film, particularly a passive film, formed by applying to the surface of base material 2 such chemical processes as oxidation, nitriding, chromating, carbonization, acid dipping, acidic electrolytic processing, alkaline dipping, or alkaline electrolytic processing.

The material of the primary coat 40 is not particularly limited, but is preferably a metal material such as Cu, Co, Pd, Au, Ag, In, Sn, Ni, Ti, Zn, Al, Fe, Cr, Pt, Rh, Ru, Zr, Hf, Ta, Ir, or an alloy composed of at least one of the preceding metal materials, or a metallic compound (such as a metal oxide, metal nitride, or metal carbide) of at least one of these metal materials, or a combination of two or more of these.

If the primary coat 40 is a metal layer of or an alloy composed of at least one of Cu, Co, Pd, Au, Ag, In, Sn, Ni, Ti, Zn, Al, Fe, Cr, Pt, Rh, Ru, and Ir, corrosion due to a potential difference between base material 2 and film 3 can be prevented even more effectively.

Furthermore, adhesion between base material 2 and film 3 can be further improved when primary coat 40 is a metal layer as described above. By thus improving the adhesion between base material 2 and film 3 the corrosion resistance of decorative article 1B is further improved. As a result, decorative article 1B offers particularly excellent durability.

Furthermore, if the primary coat 40 is a metal layer of or an alloy composed of at least one of Cu, Co, Pd, Au, Ag, In, Sn, Ni, Ti, Zn, the above-described effects of the metal layer are even more pronounced.

Furthermore, if the primary coat 40 is a metal layer of Pd or an alloy layer containing Pd, diffusion of film 3 constituents (particularly Au) into the primary coat 40 and base material 2 can be more effectively prevented. As a result, decorative article 1B offers even better long-term stability.

If the primary coat 40 is a metal layer as described above the average thickness thereof is preferably 0.05 to 50 µm, for example, and further preferably 0.1 to 10 µm. If the average thickness of primary coat 40 (metal layer) is less than the above lower limit, the effect of primary coat 40 (the effect of the metal layer) may not be sufficiently exhibited. On the other hand, if the average thickness of primary coat 40 (metal layer) is greater than the above upper limit, there is a tendency to greater variation in the film thickness in each part of the primary coat 40. Internal stress also rises in the primary coat 40 and cracks occur easily.

Furthermore, if the primary coat 40 is a metal nitride layer composed of at least one nitride of Ti, Zr, Hf, Ta, or Cr, primary coat 40 hardness is particularly high. As a result, the resulting decorative article 1B has particularly high durability.

Furthermore, if the primary coat 40 is a metal nitride layer composed of at least one nitride of Ti, Zr, Hf, Ta, or Cr, the color of primary coat 40 is a gold color with particularly high luster. As a result, the appearance of decorative article 1B is particularly excellent even when the average thickness of film 3 is relatively thin.

If the primary coat 40 is a metal nitride layer as described above the average thickness thereof is preferably 0.01 to 10 µm, for example, and further preferably 0.1 to 3 µm. If the average thickness of primary coat 40 (metal nitride layer) is less than the above lower limit, the effect of primary coat 40 (the effect of the metal nitride layer) may not be sufficiently exhibited. On the other hand, if the average thickness of primary coat 40 (metal nitride layer) is greater than the above upper limit, there is a tendency to greater variation in the film thickness in each part of the primary coat 40. Internal stress also rises in the primary coat 40 and cracks occur easily.

The constituent materials of primary coat 40 preferably include at least one of the materials composing base material 2 or the materials composing film 3. This further improves adhesion with base material 2 and film 3. By thus improving adhesion with base material 2 and film 3, the corrosion resistance of decorative article 1B can be even further improved. As a result, the decorative article 1B has particularly excellent durability.

The standard potential of primary coat 40 is preferably between the standard potential of base material 2 and the standard potential of film 3. In other words, the primary coat 40 is preferably made from a material with a standard potential between the standard potential of the constituent materials of base material 2 and the standard potential of the constituent materials of film 3. This makes it possible to prevent corrosion (contact corrosion between different types of metals) due to the potential difference between base material 2 and film 3 even more effectively.

It should be noted that, in the configuration shown in the figure primary coat 40 is shown covering the entire surface of the base material 2, but could be formed to only part of the surface of base material 2.

Furthermore, the composition in each part of primary coat 40 could be constant or not constant. For example, the composition of primary coat 40 could be one (a gradient material) that changes gradually through the thickness direction thereof.

Furthermore, the primary coat 40 shall not be limited to having the functions described above. For example, the primary coat 40 could function to prevent corrosion during storage (the period until the film 3 formation step).

A third embodiment of a surface processing method, decorative article and timepiece according to the present invention is described next.

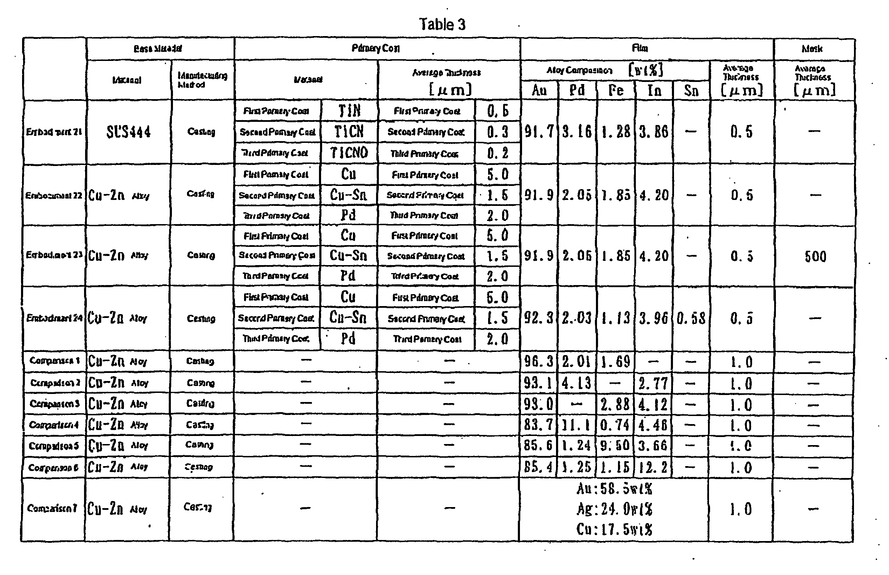

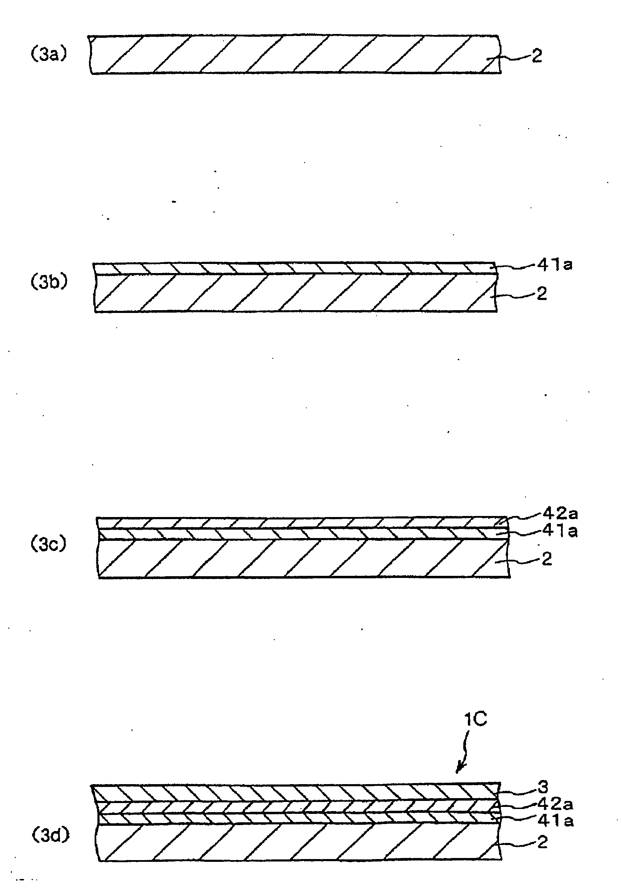

Fig. 3 is a section view showing a third embodiment of a surface processing method according to the present invention.

It should be noted that the surface processing method of this third embodiment and a decorative article according to this third embodiment manufactured using this method are described below focusing on the differences with the above first and second embodiments, and further description of the same items is omitted below.

As shown in Fig. 3 the surface processing method according to this embodiment of the invention has steps (3b, 3c) for forming primary coats (a first primary coat 41a and a second primary coat 42a in sequence from the base material side) on at least part of the surface (3a) of base material 2, and a step (3d) for forming a film 3 composed of a Au-Pd-Fe-In alloy on at least part of the primary coat surface using a dry plating method.

In other words, except that the primary coat formed on at least part of the surface of base material 2 before forming film 3 has two layers (a first primary coat 41a and a second primary coat 42a, this embodiment is the same as the second embodiment described above.

The first primary coat 41a and second primary coat 42a are described below.

### * First primary coat 41a]

A first primary coat 41a is formed on the surface of base material 2. This first primary coat 41a can be formed for any desired purpose, but preferably has the following functions.

This first primary coat 41a preferably functions as a buffer layer for buffering the potential difference between base material 2 and second primary coat 42a described below, for example. As a result, corrosion (contact corrosion between metals of different types) due to the potential difference between base material 2 and second primary coat 42a can be effectively prevented.

Furthermore, this first primary coat 41a further preferably functions to improve adhesion between base material 2 and second primary coat 42a. By thus improving adhesion between base material 2 and second primary coat 42a, the corrosion resistance of decorative article 1C can be even further improved. As a result, decorative article 1C has particularly excellent durability.

In addition, first primary coat 41a could also function to repair holes and scratches, for example, in base material 2 by a levelling effect.

The first primary coat 41a can be formed by, for example, wet plating methods such as electrolytic plating, immersion plating, or electroless plating, vacuum deposition, sputtering, thermal CVD, plasma CVD, laser CVD and other chemical vapor deposition (CVD) methods, ion plating or other dry plating method, flame coating, or metal foil bonding, but of these a wet plating method or dry plating method is preferable. By using a wet plating method or dry plating method as the first primary coat 41a formation method the resulting first primary coat 41a has particularly good adhesion- with the base material 2. As a result, the long-term durability of the resulting decorative article 1C is particularly excellent.

Furthermore, the first primary coat 41a can be a film, particularly a passive film, formed by applying to the surface of base material 2 such chemical processes as oxidation, nitriding, chromating, carbonization, acid dipping, acidic electrolytic processing, alkaline dipping, or alkaline electrolytic processing.

The material of the first primary coat 41a is not particularly limited, but is preferably a metal material such as Cu, Co, Pd, Au, Ag, In, Sn, Ni, Ti, Zn, Al, Fe, Cr, Pt, Rh, Ru, Zr, Hf, Ta, Ir, or an alloy composed of at least one of the preceding metal materials, or a metallic compound (such as a metal oxide, metal nitride, or metal carbide) of at least one of these metal materials, or a combination of two or more of these, and of these a metal layer of or an alloy composed of at least one of Cu, Co, Pd, Au, Ag, In, Sn, Ni, Ti, Zn, Al, Fe, Cr, Pt, Rh, Ru, and Ir is preferable. When the first primary coat 41a is a metal layer composed of such materials, corrosion due to a potential difference between the base material 2 and second primary coat 42a can be prevented even more effectively.

Furthermore, when the first primary coat 41a is a metal layer as described above, adhesion between base material 2 and second primary coat 42a can also be improved. By thus improving the adhesion between base material 2 and second primary coat 42a, the corrosion resistance of decorative article 1C is further improved. As a result, decorative article 1C offers particularly excellent durability.

Furthermore, if the second primary coat 42a is a metal layer, the first primary coat 41a is preferably a metal layer of or an alloy composed of at least one of Cu, Co, In, Sn, Ni, Zn, Al, or Fe. In this case the above-described effects are even more pronounced.

If the first primary coat 41a is a metal layer as described above the average thickness thereof is preferably 0.05 to 50 µm, for example, and further preferably 0.1 to 10 µm. If the average thickness of first primary coat 41a (metal layer) is less than the above lower limit, the effect of first primary coat 41a (the effect of the metal layer) may not be sufficiently exhibited. On the other hand, if the average thickness of first primary coat 41a (metal layer) is greater than the above upper limit, there is a tendency to greater variation in the film thickness in each part of the first primary coat 41a.

Internal stress also rises in the first primary coat 41a and cracks occur easily.

The constituent materials of first primary coat 41a preferably include at least one of the materials composing base material 2 or the materials composing second primary coat 42a. This further improves adhesion with base material 2 and second primary coat 42a. By thus improving adhesion with base material 2 and second primary coat 42a, the corrosion resistance of decorative article 1C can be even further improved. As a result, the decorative article 1C has particularly excellent durability.

The standard potential of first primary coat 41a is preferably between the standard potential of base material 2 and the standard potential of second primary coat 42a. In other words, the first primary coat 41a is preferably made from a material with a standard potential between the standard potential of the constituent materials of base material 2 and the standard potential of the constituent materials of second primary coat 42a. This makes it possible to prevent corrosion (contact corrosion between different types of metals) due to the potential difference between base material 2 and second primary coat 42a even more effectively.

It should be noted that, in the configuration shown in the figure first primary coat 41a is shown covering the entire surface of the base material 2, but could be formed to only part of the surface of base material 2.

Furthermore, the composition in each part of first primary coat 41a could be constant or not constant. For example, the composition of first primary coat 41a could be one (a gradient material) that changes gradually through the thickness direction thereof.

Furthermore, the first primary coat 41a shall not be limited to having the functions described above. For example, the first primary coat 41a could function to prevent corrosion during storage (the period until the film 3 formation step).

### * Second primary coat 42a]

Next, second primary coat 42a is formed on the surface of first primary coat 41a. This second primary coat 42a can be formed for any desired purpose, but preferably has the following functions.

This second primary coat 42a preferably functions as a buffer layer for buffering the potential difference between first primary coat 41a and film 3. As a result, corrosion (contact corrosion between metals of different types) due to the potential difference between first primary coat 41a and film 3 can be effectively prevented.

Furthermore, second primary coat 42a preferably has high hardness. This makes it possible to achieve a decorative article 1C with high hardness, and as a result the decorative article 1C features excellent durability. Vickers hardness Hv, for example, can be used as a hardness index. The Vickers hardness Hv of second primary coat 42a is preferably greater than or equal to 100, further preferably greater than or equal to 150, and yet further preferably greater than or equal to 1700. If the Vickers hardness Hv of second primary coat 42a is such a level, the above-described effects are even more pronounced.

Furthermore, second primary coat 42a preferably functions to improve adhesion between first primary coat 41a and film 3, for example. By thus improving adhesion between first primary coat 41a and film 3, the corrosion resistance of decorative article 1C can be even further improved. As a result, decorative article 1C has particularly excellent durability.

In addition, second primary coat 42a could also function to repair holes and scratches, for example, in first primary coat 41a by a levelling effect.

The second primary coat 42a can be formed by, for example, wet plating methods such as electrolytic plating, immersion plating, or electroless plating, vacuum deposition, sputtering, thermal CVD, plasma CVD, laser CVD and other chemical vapor deposition (CVD) methods, ion plating or other dry plating method, flame coating, or metal foil bonding, but of these a wet plating method or dry plating method is preferable. By using a wet plating method or dry plating method as the second primary coat 42a formation method the resulting second primary coat 42a has particularly good adhesion with the first primary coat 41a. As a result, the long-term durability of the resulting decorative article 1C is particularly excellent.

Furthermore, the second primary coat 42a can be a film, particularly a passive film, formed by applying to the surface of first primary coat 41a such chemical processes as oxidation, nitriding, chromating, carbonization, acid dipping, acidic electrolytic processing, alkaline dipping, or alkaline electrolytic processing.

The material of the second primary coat 42a is not particularly limited, but is preferably a metal material such as Cu, Co, Pd, Au, Ag, In, Sn, Ni, Ti, Zn, Al, Fe, Cr, Pt, Rh, Ru, Zr, Hf, Ta, Ir, or an alloy composed of at least one of the preceding metal materials, or a metallic compound (such as a metal oxide, metal nitride, or metal carbide) of at least one of these metal materials, or a combination of two or more of these.

If the second primary coat 42a is a metal layer of or an alloy composed of at least one of Cu, Co, Pd, Au, Ag, In, Sn, Ni, Ti, Zn, Al, Fe, Cr, Pt, Rh, Ru, and Ir, corrosion due to a potential difference between first primary coat 41a and film 3 can be prevented even more effectively.

Furthermore, adhesion between first primary coat 41a and film 3 can be further improved when second primary coat 42a is a metal layer as described above. By thus improving the adhesion between first primary coat 41a and film 3 the corrosion resistance of decorative article 1C is further improved. As a result, decorative article 1C offers particularly excellent durability.

Furthermore, if the first primary coat 41a is a metal layer, the second primary coat 42a (metal layer) is preferably a metal layer of or an alloy composed of at least one of Pd, Au, Ag, Sn, Ni, Ti, Cr, Pt, Rh, and Ru. In this case the above-described effects are even more pronounced.

Furthermore, if the second primary coat 42a is a metal layer of Pd or an alloy layer containing Pd, diffusion of film 3 constituents (particularly Au) into the second primary coat 42a, first primary coat 41a, and base material 2 can be more effectively prevented. As a result, decorative article 1C offers even better long-term stability.

If the second primary coat 42a is a metal layer as described above the average thickness thereof is preferably 0.05 to 50 µm, for example, and further preferably 0.1 to 10 µm. If the average thickness of second primary coat 42a (metal layer) is less than the above lower limit, the effect of second primary coat 42a (the effect of the metal layer) may not be sufficiently exhibited. On the other hand, if the average thickness of second primary coat 42a (metal layer) is greater than the above upper limit, there is a tendency to greater variation in the film thickness in each part of the second primary coat 42a.

Internal stress also rises in the second primary coat 42a and cracks occur easily.

Furthermore, if the second primary coat 42a is a metal nitride layer composed of at least one nitride of Ti, Zr, Hf, Ta, or Cr, second primary coat 42a hardness is particularly high. As a result, the resulting decorative article 1C has particularly high durability.

Furthermore, if the second primary coat 42a is a metal nitride layer composed of at least one nitride of Ti, Zr, Hf, Ta, or Cr, the color of second primary coat 42a is a gold color with particularly high luster. As a result, the appearance of decorative article 1C is particularly excellent even when the average thickness of film 3 is relatively thin.

If the second primary coat 42a is a metal nitride layer as described above the average thickness thereof is preferably 0.01 to 10 µm, for example, and further preferably 0.5 to 3 µm. If the average thickness of second primary coat 42a (metal nitride layer) is less than the above lower limit, the effect of second primary coat 42a (the effect of the metal nitride layer) may not be sufficiently exhibited. On the other hand, if the average thickness of second primary coat 42a (metal nitride layer) is greater than the above upper limit, there is a tendency to greater variation in the film thickness in each part of the second primary coat 42a. Internal stress also rises in the second primary coat 42a and cracks occur easily.

The constituent materials of second primary coat 42a preferably include at least one of the materials composing first primary coat 41a or the materials composing film 3. This further improves adhesion with first primary coat 41a and film 3. By thus improving adhesion with first primary coat 41a and film 3, the corrosion resistance of decorative article 1C can be even further improved. As a result, the decorative article 1C has particularly excellent durability.

The standard potential of second primary coat 42a is preferably between the standard potential of first primary coat 41a and the standard potential of film 3. In other words, the second primary coat 42a is preferably made from a material with a standard potential between the standard potential of the constituent materials of first primary coat 41a and the standard potential of the constituent materials of film 3. This makes it possible to prevent corrosion (contact corrosion between different types of metals) due to the potential difference between first primary coat 41a and film 3 even more effectively.

It should be noted that, in the configuration shown in the figure second primary coat 42a is shown covering the entire surface of the first primary coat 41a, but could be formed to only part of the surface of first primary coat 41a.

Furthermore, the composition in each part of second primary coat 42a could be constant or not constant. For example, the composition of second primary coat 42a could be one (a gradient material) that changes gradually through the thickness direction thereof.

Furthermore, the second primary coat 42a shall not be limited to having the functions described above. For example, the second primary coat 42a could function to prevent corrosion during storage (the period until the film 3 formation step).

A fourth embodiment of a surface processing method, decorative article and timepiece according to the present invention is described next.

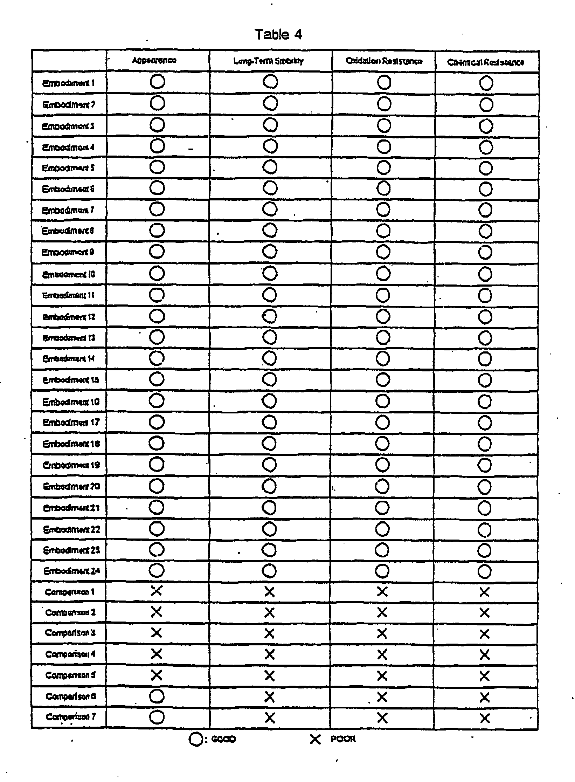

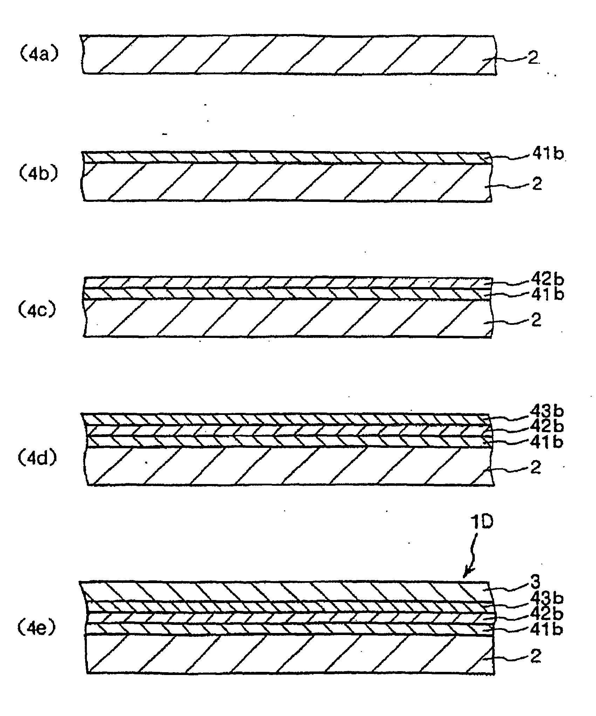

Fig. 4 is a section view showing a fourth embodiment of a surface processing method according to the present invention.

It should be noted that the surface processing method of this fourth embodiment and a decorative article according to this fourth embodiment manufactured using this method are described below focusing on the differences with the above first, second, and third embodiments, and further description of the same items is omitted below.

As shown in Fig. 4 the surface processing method according to this embodiment of the invention has steps (4b, 4c, 4d) for forming primary coats (a first primary coat 41b, second primary coat 42b, and third primary coat 43b in sequence from the base material side) on at least part of the surface (4a) of base material 2, and a step (4e) for forming a film 3 composed of a Au-Pd-Fe-In alloy on at least part of the primary coat surface using a dry plating method.

In other words, except that the primary coat formed on at least part of the surface of base material 2 before forming film 3 has three layers (a first primary coat 41b, second primary coat 42b, and third primary coat 43b), this embodiment is the same as the second and third embodiments described above.

The first primary coat 41b, second primary coat 42b, and third primary coat 43b are described below.

### * First primary coat 41b]

A first primary coat 41b is formed on the surface of base material 2. This first primary coat 41b can be formed for any desired purpose, but preferably has the following functions.

This first primary coat 41b preferably functions as a buffer layer for buffering the potential difference between base material 2 and second primary coat 42b described below, for example. As a result, corrosion (contact corrosion between metals of different types) due to the potential difference between base material 2 and second primary coat 42b can be effectively prevented.

Furthermore, this first primary coat 41b further preferably functions to improve adhesion between base material 2 and second primary coat 42b. By thus improving adhesion between base material 2 and second primary coat 42b, the corrosion resistance of decorative article 1D can be even further improved. As a result, decorative article 1D has particularly excellent durability.

In addition, first primary coat 41b could also function to repair holes and scratches, for example, in base material 2 by a levelling effect.

The first primary coat 41b can be formed by, for example, wet plating methods such as electrolytic plating, immersion plating, or electroless plating, vacuum deposition, sputtering, thermal CVD, plasma CVD, laser CVD and other chemical vapor deposition (CVD) methods, ion plating or other dry plating method, flame coating, or metal foil bonding, but of these a wet plating method or dry plating method is preferable. By using a wet plating method or dry plating method as the first primary coat 41b formation method the resulting first primary coat 41b has particularly good adhesion with the base material 2. As a result, the long-term durability of the resulting decorative article 10 is particularly excellent.

Furthermore, the first primary coat 41b can be a film, particularly a passive film, formed by applying to the surface of base material 2 such chemical processes as oxidation, nitriding, chromating, carbonization, acid dipping, acidic electrolytic processing, alkaline dipping, or alkaline electrolytic processing.

The material of the first primary coat 41b is not particularly limited, but is preferably a metal material such as Cu, Co, Pd, Au, Ag, In, Sn, Ni, Ti, Zn, Al, Fe, Cr, Pt, Rh, Ru, Zr, Hf, Ta, Ir, or an alloy composed of at least one of the preceding metal materials, or a metallic compound (such as a metal oxide, metal nitride, or metal carbide) of at least one of these metal materials, or a combination of two or more of these, and of these a metal layer of or an alloy composed of at least one of Cu, Co, Pd, Au, Ag, In, Sn, Ni, Ti, Zn, Al, Fe, Cr, Pt, Rh, Ru, and Ir is preferable. When the first primary coat 41b is a metal layer composed of such materials, corrosion due to a potential difference between the base material 2 and second primary coat 42b can be prevented even more effectively.

Furthermore, when the first primary coat 41b is a metal layer as described above, adhesion between base material 2 and second primary coat 42b can also be improved. By thus improving the adhesion between base material 2 and second primary coat 42b, the corrosion resistance of decorative article 1D is further improved. As a result, decorative article 1D offers particularly excellent durability.

If the second primary coat 42b and third primary coat 43b are made of metal layers, the first primary coat 41b is preferably a metal layer of or an alloy composed of at least one of Cu, Co, In, Sn, Ni, Zn, Al, or Fe. In this case the above-described effects are even more pronounced.

If the first primary coat 41b is a metal layer as described above the average thickness thereof is preferably 0.05 to 50 µm, for example, and further preferably 0.1 to 10 µm. If the average thickness of first primary coat 41b (metal layer) is less than the above lower limit, the effect of first primary coat 41b (the effect of the metal layer) may not be sufficiently exhibited. On the other hand, if the average thickness of first primary coat 41b (metal layer) is greater than the above upper limit, there is a tendency to greater variation in the film thickness in each part of the first primary coat 41b.

Internal stress also rises in the first primary coat 41b and cracks occur easily.

The constituent materials of first primary coat 41b preferably include at least one of the materials composing base material 2 or the materials composing second primary coat 42b. This further improves adhesion with base material 2 and second primary coat 42b. By thus improving adhesion with base material 2 and second primary coat 42b, the corrosion resistance of decorative article 1D can be even further improved. As a result, the decorative article 1D has particularly excellent durability.

The standard potential of first primary coat 41b is preferably between the standard potential of base material 2 and the standard potential of second primary coat 42b. In other words, the first primary coat 41b is preferably made from a material with a standard potential between the standard potential of the constituent materials of base material 2 and the standard potential of the constituent materials of second primary coat 42b. This makes it possible to prevent corrosion (contact corrosion between different types of metals) due to the potential difference between base material 2 and second primary coat 42b even more effectively.

It should be noted that, in the configuration shown in the figure first primary coat 41b is shown covering the entire surface of the base material 2, but could be formed to only part of the surface of base material 2.

Furthermore, the composition in each part of first primary coat 41b could be constant or not constant. For example, the composition of first primary coat 41b could be one (a gradient material) that changes gradually through the thickness direction thereof.

Furthermore, the first primary coat 41b shall not be limited to having the functions described above. For example, the first primary coat 41b could function to prevent corrosion during storage (the period until the film 3 formation step).

### * Second primary coat 42b]

Next, second primary coat 42b is formed on the surface of first primary coat 41b. This second primary coat 42b can be formed for any desired purpose, but preferably has the following functions.

This second primary coat 42b preferably functions as a buffer layer for buffering the potential difference between first primary coat 41b and third primary coat 43b. As a result, corrosion (contact corrosion between metals of different types) due to the potential difference between first primary coat 41b and third primary coat 43b can be effectively prevented.

Furthermore, second primary coat 42b preferably functions to improve adhesion between first primary coat 41b and third primary coat 43b, for example. By thus improving adhesion between first primary coat 41b and third primary coat 43b, the corrosion resistance of decorative article 1D can be even further improved. As a result, decorative article 1D has particularly excellent durability.

In addition, second primary coat 42b could also function to repair holes and scratches, for example, in first primary coat 41b by a levelling effect.

The second primary coat 42b can be formed by, for example, wet plating methods such as electrolytic plating, immersion plating, or electroless plating, vacuum deposition, sputtering, thermal CVD, plasma CVD, laser CVD and other chemical vapor deposition (CVD) methods, ion plating or other dry plating method, flame coating, or metal foil bonding, but of these a wet plating method or dry plating method is preferable. By using a wet plating method or dry plating method as the second primary coat 42b formation method the resulting second primary coat 42b has particularly good adhesion with the first primary coat 41b. As a result, the long-term durability of the resulting decorative article 1D is particularly excellent.

Furthermore, the second primary coat 42b can be a film, particularly a passive film, formed by applying to the surface of first primary coat 41b such chemical processes as oxidation, nitriding, chromating, carbonization, acid dipping, acidic electrolytic processing, alkaline dipping, or alkaline electrolytic processing.

The material of the second primary coat 42b is not particularly limited, but is preferably a metal material such as Cu, Co, Pd, Au, Ag, In, Sn, Ni, Ti, Zn, Al, Fe, Cr, Pt, Rh, Ru, Zr, Hf, Ta, Ir, or an alloy composed of at least one of the preceding metal materials, or a metallic compound (such as a metal oxide, metal nitride, or metal carbide) of at least one of these metal materials, or a combination of two or more of these, and of these a metal layer of or an alloy composed of at least one of Cu, Co, Pd, Au, Ag, In, Sn, Ni, Ti, Zn, Al, Fe, Cr, Pt, Rh, Ru, and Ir is preferable. When the second primary coat 42b is a metal layer composed of such materials, corrosion due to a potential difference between the first primary coat 41b and third primary coat 43b can be prevented even more effectively.

Furthermore, when the second primary coat 42b is a metal layer as described above, adhesion between first primary coat 41b and third primary coat 43b can also be improved. By thus improving the adhesion between first primary coat 41b and third primary coat 43b, the corrosion resistance of decorative article 1D is further improved. As a result, decorative article 1D offers particularly excellent durability.

Furthermore, if the first primary coat 41b and the third primary coat 43b are metal layers, the second primary coat 42b is preferably a metal layer of or an alloy composed of at least one of Cu, Pd, Au, Ag, In, Sn, Ti, Zn, Fe, and Cr. In this case the above-described effects are even more pronounced.

If the second primary coat 42b is a metal layer as described above the average thickness thereof is preferably 0.05 to 50 µm, for example, and further preferably 0.1 to 10 µm. If the average thickness of second primary coat 42b (metal layer) is less than the above lower limit, the effect of second primary coat 42b (the effect of the metal layer) may not be sufficiently exhibited. On the other hand, if the average thickness of second primary coat 42b (metal layer) is greater than the above upper limit, there is a tendency to greater variation in the film thickness in each part of the second primary coat 42b.

Internal stress also rises in the second primary coat 42b and cracks occur easily.

The constituent materials of second primary coat 42b preferably include at least one of the materials composing first primary coat 41b or the materials composing third primary coat 43b. This further improves adhesion with first primary coat 41b and third primary coat 43b. By thus improving adhesion with first primary coat 41b and third primary coat 43b, the corrosion resistance of decorative article 1D can be even further improved. As a result, the decorative article 1D has particularly excellent durability.

The standard potential of second primary coat 42b is preferably between the standard potential of first primary coat 41b and the standard potential of third primary coat 43b. In other words, the second primary coat 42b is preferably made from a material with a standard potential between the standard potential of the constituent materials of first primary coat 41b and the standard potential of the constituent materials of third primary coat 43b. This makes it possible to prevent corrosion (contact corrosion between different types of metals) due to the potential difference between first primary coat 41b and third primary coat 43b even more effectively.

It should be noted that, in the configuration shown in the figure second primary coat 42b is shown covering the entire surface of the first primary coat 41b, but could be formed to only part of the surface of first primary coat 41b.

Furthermore, the composition in each part of second primary coat 42b could be constant or not constant. For example, the composition of second primary coat 42b could be one (a gradient material) that changes gradually through the thickness direction thereof.

Furthermore, the second primary coat 42b shall not be limited to having the functions described above. For example, the second primary coat 42b could function to prevent corrosion during storage (the period until the film 3 formation step).

### * Third primary coat 43b]

Next, third primary coat 43b is formed on the surface of second primary coat 42b. This third primary coat 43b can be formed for any desired purpose, but preferably has the following functions.

This third primary coat 43b preferably functions as a buffer layer for buffering the potential difference between second primary coat 42b and film 3. As a result, corrosion (contact corrosion between metals of different types) due to the potential difference between second primary coat 42b and film 3 can be effectively prevented.

Furthermore, third primary coat 43b preferably has high hardness. This makes it possible to achieve a decorative article 1D with high hardness, and as a result the decorative article 1D features excellent durability. Vickers hardness Hv, for example, can be used as a hardness index. The Vickers hardness Hv of third primary coat 43b is preferably greater than or equal to 100, further preferably greater than or equal to 150, and yet further preferably greater than or equal to 1700. If the Vickers hardness Hv of third primary coat 43b is such a level, the above-described effects are even more pronounced.

Furthermore, third primary coat 43b preferably functions to improve adhesion between second primary coat 42b and film 3, for example. By thus improving adhesion between second primary coat 42b and film 3, the corrosion resistance of decorative article 1D can be even further improved. As a result, decorative article 1D has particularly excellent durability.

In addition, third primary coat 43b could also function to repair holes and scratches, for example, in second primary coat 42b by levelling.

The third primary coat 43b can be formed by, for example, wet plating methods such as electrolytic plating, immersion plating, or electroless plating, vacuum deposition, sputtering, thermal CVD, plasma CVD, laser CVD and other chemical vapor deposition (CVD) methods, ion plating or other dry plating method, flame coating, or metal foil bonding, but of these a wet plating method or dry plating method is preferable. By using a wet plating method or dry plating method as the third primary coat 43b formation method the resulting third primary coat 43b has particularly good adhesion with the second primary coat 42b. As a result, the long-term durability of the resulting decorative article 1D is particularly excellent.

Furthermore, the third primary coat 43b can be a film, particularly a passive film, formed by applying to the surface of second primary coat 42b such chemical processes as oxidation, nitriding, chromating, carbonization, acid dipping, acidic electrolytic processing, alkaline dipping, or alkaline electrolytic processing.

The material of the third primary coat 43b is not particularly limited, but is preferably a metal material such as Cu, Co, Pd, Au, Ag, In, Sn, Ni, Ti, Zn, Al, Fe, Cr, Pt, Rh, Ru, Zr, Hf, Ta, Ir, or an alloy composed of at least one of the preceding metal materials, or a metallic compound (such as a metal oxide, metal nitride, or metal carbide) of at least one of these metal materials, or a combination of two or more of these.

If the third primary coat 43b is a metal layer of or an alloy composed of at least one of Cu, Co, Pd, Au, Ag, In, Sn, Ni, Ti, Zn, Al, Fe, Cr, Pt, Rh, Ru, and Ir, corrosion due to a potential difference between second primary coat 42b and film 3 can be prevented even more effectively.

Furthermore, adhesion between second primary coat 42b and film 3 can be further improved when third primary coat 43b is a metal layer as described above. By thus improving the adhesion between second primary coat 42b and film 3 the corrosion resistance of decorative article 1D is further improved. As a result, decorative article 1D offers particularly excellent durability.

Furthermore, if the first primary coat 41b and second primary coat 42b are metal layers, the third primary coat 43b (metal layer) is preferably a metal layer of or an alloy composed of at least one of Pd, Au, Ag, Sn, Ni, Ti, Cr, Pt, Rh, and Ru. In this case the above-described effects are even more pronounced.

Furthermore, if the third primary coat 43b is a metal layer of Pd or an alloy layer containing Pd, diffusion of film 3 constituents (particularly Au) into the third primary coat 43b, second primary coat 42b, first primary coat 41b, and base material 2 can be more effectively prevented. As a result, decorative article 1D offers even better long-term stability.

If the third primary coat 43b is a metal layer as described above the average thickness thereof is preferably 0.05 to 50 µm, for example, and further preferably 0.1 to 10 µm. If the average thickness of third primary coat 43b (metal layer) is less than the above lower limit, the effect of third primary coat 43b (the effect of the metal layer) may not be sufficiently exhibited. On the other hand, if the average thickness of third primary coat 43b (metal layer) is greater than the above upper limit, there is a tendency to greater variation in the film thickness in each part of the third primary coat 43b.

Internal stress also rises in the third primary coat 43b and cracks occur easily.

Furthermore, if the third primary coat 43b is a metal nitride layer composed of at least one nitride of Ti, Zr, Hf, Ta, or Cr, third primary coat 43b hardness is particularly high. As a result, the resulting decorative article 1D has particularly high durability.

Furthermore, if the third primary coat 43b is a metal nitride layer composed of at least one nitride of Ti, Zr, Hf, Ta, or Cr, the color of third primary coat 43b is a gold color with particularly high luster. As a result, the appearance of decorative article 1D is particularly excellent even when the average thickness of film 3 is relatively thin.

If the third primary coat 43b is a metal nitride layer as described above the average thickness thereof is preferably 0.01 to 10 µm, for example, and further preferably 0.5 to 3 µm. If the average thickness of third primary coat 43b (metal nitride layer) is less than the above lower limit, the effect of third primary coat 43b (the effect of the metal nitride layer) may not be sufficiently exhibited. On the other hand, if the average thickness of third primary coat 43b (metal nitride layer) is greater than the above upper limit, there is a tendency to greater variation in the film thickness in each part of the third primary coat 43b. Internal stress also rises in the third primary coat 43b and cracks occur easily.

The constituent materials of third primary coat 43b preferably include at least one of the materials composing second primary coat 42b or the materials composing film 3. This further improves adhesion with second primary coat 42b and film 3. By thus improving adhesion with second primary coat 42b and film 3, the corrosion resistance of decorative article 1D can be even further improved. As a result, the decorative article 1D has particularly excellent durability.

The standard potential of third primary coat 43b is preferably between the standard potential of second primary coat 42b and the standard potential of film 3. In other words, the third primary coat 43b is preferably made from a material with a standard potential between the standard potential of the constituent materials of second primary coat 42b and the standard potential of the constituent materials of film 3. This makes it possible to prevent corrosion (contact corrosion between different types of metals) due to the potential difference between second primary coat 42b and film 3 even more effectively.

It should be noted that, in the configuration shown in the figure third primary coat 43b is shown covering the entire surface of the second primary coat 42b, but could be formed to only part of the surface of second primary coat 42b.

Furthermore, the composition in each part of third primary coat 43b could be constant or not constant. For example, the composition of third primary coat 43b could be one (a gradient material) that changes gradually through the thickness direction thereof.

Furthermore, the third primary coat 43b shall not be limited to having the functions described above. For example, the third primary coat 43b could function to prevent corrosion during storage (the period until the film 3 formation step).

A fifth embodiment of a surface processing method, decorative article and timepiece according to the present invention is described next.

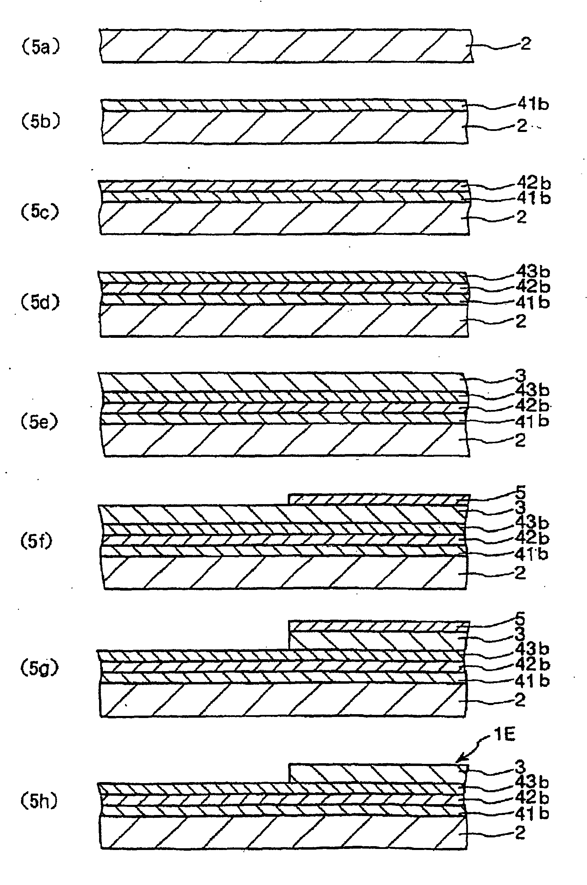

Fig. 5 is a section view showing a fourth embodiment of a surface processing method according to the present invention.

It should be noted that the surface processing method of this fifth embodiment and a decorative article according to this fifth embodiment manufactured using this method are described below focusing on the differences with the above first, second, third and fourth embodiments, and further description of the same items is omitted below.

As shown in Fig. 5 the surface processing method according to this embodiment of the invention has steps (5b, 5c, 5d) for forming primary coats (a first primary coat 41b, second primary coat 42b, and third primary coat 43b) on at least part of the surface (5a) of base material 2, a step (5e) for forming a film 3 primarily composed of a chrome compound on at least part of the primary coat surface using a dry plating method, a step (5f) for forming a mask 5 on part of the surface of film 3, a step (5g) for removing film 3 in the areas not covered by mask 5 using a stripping agent, and a step (5h) for removing the mask 5.

In other words, this embodiment is identical to the above-described fourth embodiment except for the step (5f) for forming a mask 5 on part of the surface of film 3 after forming the film 3, the step (5g) for removing film 3 in the areas not covered by mask 5 using a stripping agent, and the step (5h) for removing the mask 5.

### * Applying a mask]

After the film 3 is formed part of the surface of film 3 is covered with a mask 5 (5f). This mask 5 functions to protect the covered parts of film 3 in the step described below for removing the film 3.

The mask 5 can be any material that functions to protect the covered parts of film 3 in the step for removing the film 3, but is preferably also easily removed in the step described below for removing the mask 5.

Materials that could be used to form such a mask 5 include resin materials such as acrylic resins, polyimide resins, polysulfone resins, epoxy resins, fluororesins, and rubber resins, or metal material such as Au, Ni, Pd, Cu, Ag, Ti and Cr.

The method for forming mask 5 shall not be specifically limited, and possible methods include coating methods such as dipping, brush application, spray coating, electrostatic coating, electrodeposition coating, wet plating methods such as electrolytic plating, immersion plating, or electroless plating, chemical vapor deposition (CVD) methods such as thermal CVD, plasma CVD, and laser CVD, vacuum deposition, sputtering, ion plating and other dry plating methods, and flame coating.

The average thickness of mask 5 is not specifically limited, but is, for example, preferably 100 to 2000 µm, and further preferably 500 to 1000 µm. If the average thickness of the mask 5 is less than the above lower limit, there is a tendency for pinholes to form easily in the mask 5. As a result, in the step for removing the film 3 described below part of the film 3 in the area covered by mask 5 will also dissolve and be removed, and there is the potential for a drop in the aesthetic appearance of the resulting decorative article 1E. On the other hand, if the average thickness of the mask 5 is above the above upper limit, there is a tendency for greater variation in the film thickness in different parts of the mask 5. In addition, internal stress in the mask 5 increases, adhesion between the mask 5 and film 3 decreases, and cracks occur easily.

The mask 5 is further preferably transparent. This enables adhesion with the film 3 to be externally visually confirmed.

The mask 5 is not limited to a mask that is formed to a desired shape directly on the surface of film 3. For example, a mask 5 with a desired pattern could be formed by first applying the mask 5 material to substantially the entire surface of the film 3, and then removing selected parts.

Methods for removing part of the mask 5 coated to substantially the entire surface of film 3 include, for example, methods emitting a laser beam to the parts of mask 5 to be removed. Lasers that could be used for this include, for example, an Ne-He laser, Ar laser, CO₂ laser or other gas laser, a ruby laser, semiconductor laser, YAG laser, glass laser, YVO₄ laser, and an excimer laser.

### * Removing the film]

Next, the film 3 is removed from the parts not covered by mask 5 (5g).

The film 3 is removed using a stripping agent that is capable of removing the film 3 but does not actually dissolve and remove the mask 5.

The stripping agent used to remove the film 3 shall not be specifically limited insofar as it can remove the film 3 without actually dissolving and removing the mask 5, but is preferably a liquid, gas, or other fluid, and of these is preferably a liquid. This enables the film 3 to- be removed easily and dependably.

A stripping solution containing potassium cyanide (KCN), for example, could be used as the stripping agent. An aqueous solution containing, for example, approximately 30 to 60 g/liter potassium cyanide could be used as such a stripping solution.

It should be noted that the stripping agent could contain various additives such as a stabilizer, stripping accelerator, organic components, and catalysts.

Methods that could be used to remove the film 3 include, for example, spraying the stripping agent, immersion in a liquid state stripping agent (dipping), and using electrolysis during immersion in a liquid state stripping agent (stripping solution), but of these methods for dipping in a liquid state stripping agent (stripping solution) are particularly preferable. This enables the film 3 to be removed easily and dependably.

When the film 3 is removed by dipping in a liquid state stripping agent (stripping solution), the temperature of the stripping agent is not specifically limited but is, for example, preferably 10 to 100°C, further preferably 20 to 80°C, and yet further preferably 20 to 50°C. If the temperature of the stripping agent is below the above lower limit, it may take a long time to sufficiently remove the film 3 in the areas not coated with the mask 5 depending upon the thickness of film 3, and productivity of the decorative article 1E drops. On the other hand, if the temperature of the stripping agent is above the above upper limit, evaporation of the stripping agent may increase depending upon the vapor pressure and boiling point of the stripping agent, and the amount of stripping agent required to remove the film 3 tends to increase.

The dipping time in the stripping agent is not specifically limited, but is, for example, preferably 1 to 40 minutes, and is yet further preferably 5 to 20 minutes. If the dipping time in the stripping agent is less than the above lower limit, there are cases in which it could be difficult to sufficiently remove the film 3 in areas not covered by the mask 5 depending upon the film 3 thickness and the temperature of the stripping agent, for example. On the other hand, decorative article 1E productivity drops if the stripping agent dipping time exceeds the above upper limits.

It should be noted that when the film 3 is removed by dipping in a liquid state stripping agent (stripping solution), vibration (such as ultrasonic vibration) may be applied to the stripping agent during immersion. This can improve the efficiency of film 3 removal.

### * Removing the mask]

The decorative article 1E is then obtained by removing the mask 5.

The mask 5 can be removed using any method, but a using a mask removal agent that can remove the mask 5 while also not actually damaging the base material 2 and film 3 is preferable. By using such a mask removal agent the mask 5 can be removed easily and dependably.

The mask removal agent used to remove the mask 5 shall not be specifically limited, but is preferably a liquid, gas, or other fluid, and of these is preferably a liquid. This enables the mask 5 to be removed even more easily and dependably.

The mask removal agent could be, for example, nitric acid, sulfuric acid, ammonia, hydrogen peroxide, water, carbon disulfide, carbon tetrachloride or other inorganic solvent; ketone solvents such as methyl ethyl ketone (MEK), acetone, diethylketone, methyl isobutyl ketone (MIBK), methyl isopropyl ketone (MIPK), and cyclohexanone; alcohol solvents such as methanol, ethanol, isopropanol, ethylene glycol, diethylene glycol (DEG), and glycerine; ether solvents such as diethyl ether, diisopropyl ether, 1,2-dimethoxyethane, 1,4-dioxane, tetrahydrofuran (THF), tetrahydropyran (THP), anisole, and diethylene glycol dimethyl ether (diglyme); cellosolve solvents such as methyl cellosolve, ethyl cellosolve, and phenyl cellosolve; aliphatic hydrocarbon solvents such as hexane, pentane, heptane, and cyclohexane; aromatic hydrocarbon solvents such as toluene, xylene, and benzene; aromatic heterocyclic compound solvents such as pyridine, pyrazine, furan, pyrrole, and thiophene; amide solvents such as N,N-dimethylformamide (DMF), and N,N-dimethylacetoamide (DMA); halogen compound solvents such as dichloromethane, chloroform, and 1,2-dichloroethane; ester solvents such as ethyl acetate, methyl acetate, and ethyl formate; sulfur compound solvents such as dimethyl sulfoxide (DMSO) and sulfolane; nitryl solvents such as acetonitrile and propionitrile; organic acid solvents such as formic acid, acetic acid, trichloroacetic acid, and trifluoroacetic acid; or a mixture of two or more of these; or a mixture of these and an acid material of nitric acid, sulfuric acid, hydrogen chloride, hydrogen fluoride, or phosphoric acid, for example; an alkaline material such as sodium hydroxide, potassium hydroxide, lithium hydroxide, calcium hydroxide, magnesium hydroxide, or ammonia; an oxidizing agent such as potassium permanganate (KMnO₄), magnesium dioxide (MnO₂), potassium dichromate (K₂Cr₂O₇), ozone, concentrated sulfuric acid, nitric acid, chloride of lime, hydrogen peroxide, or quinone; or a reducing agent such as sodium thiosulfate (Na₂S₂O₃), hydrogen sulfide, hydrogen peroxide, or hydroquinone.

Methods of removing the mask 5 include, for example, spraying the mask removal agent, dipping in a liquid state mask removal agent, and using electrolysis while immersed in a liquid state mask removal agent, and of these a method for dipping an a liquid state mask removal agent is particularly preferable. This enables the mask 5 to be removed easily and dependably.

When the mask 5 is removed by dipping in a liquid state mask removal agent, the temperature of the mask removal agent is not specifically limited but is, for example, preferably 15 to 100°C, and further preferably 30 to 50°C. If the temperature of the mask removal agent is below the above lower limit, it may take a long time to sufficiently remove the mask 5 depending upon the thickness of mask 5, and productivity of the decorative article 1E drops. On the other hand, if the temperature of the mask removal agent is above the above upper limit, evaporation of the mask removal agent may increase depending upon the vapor pressure and boiling point of the mask removal agent, and the amount of mask removal agent required to remove the mask 5 tends to increase.

The dipping time in the mask removal agent is not specifically limited, but is, for example, preferably 5 to 60 minutes, and is yet further preferably 5 to 30 minutes. If the dipping time in the mask removal agent is less than the above lower limit, there are cases in which it could be difficult to sufficiently remove the mask 5 depending upon the mask 5 thickness and the temperature of the mask removal agent, for example. On the other hand, decorative article 1E productivity drops if the mask removal agent dipping time exceeds the above upper limits.

It should be noted that when the mask 5 is removed by dipping in a liquid state mask removal agent, vibration (such as ultrasonic vibration) may be applied to the mask removal agent during immersion. This can improve the efficiency of mask 5 removal.

By thus removing part of the film 3, the film 3 can be easily patterned to a desired shape.

Furthermore, by removing part of film 3 to, for example, form a relief pattern of areas where film 3 remains and areas where film 3 is removed, pronounced color differences can be imparted. As a result, an even more outstanding aesthetic appearance can be achieved in the decorative article 1E.

Preferred embodiments of a surface processing method, decorative article, and timepiece according to the present invention are described above, but the present invention shall not be limited thereto.

For example, a single primary coat (primary coat 40) is formed in the second embodiment described above, two primary coats (first primary coat 41a, second primary coat 42a) are formed in the third embodiment, and three primary coats (first primary coat 41b, second primary coat 42b, third primary coat 43b) are formed in the fourth and fifth embodiments, but the primary coat could be formed with four or more layers. In this case at least one of the primary coats preferably functions to buffer the potential difference between one side of the layer and the other side of the layer.

Furthermore, if there are four or more primary coats any two adjacent primary coats are preferably made of materials containing one common element as described above.

This improves adhesion between the adjacent primary coats. In addition, if the common element is Cu adhesion between the adjacent primary coats is particularly good.

Furthermore, if there are four or more primary coats the primary coats are preferably metal layers or metal nitride layers as in the embodiments described above. Particularly when at least one of the primary coats is a metal nitride layer, at least the layer contacting the film is preferably a metal nitride layer. This results in a decorative article with particularly excellent durability, and a decorative article with an outstanding aesthetic appearance.

A protective layer imparting corrosion resistance, weather resistance, water resistance, oil resistance, wear resistance, or resistance to color change can also be formed to at least part of the surface of the decorative article to improve protection against rust, soiling, and dulling.

Furthermore, part of the film 3 is removed in the fifth embodiment, but at least part of the primary coats (first primary coat, second primary coat, third primary coat) therebelow may be removed with the film 3. For example, if the primary coat is made of Ti or a Ti alloy, the primary coat can be removed using a solution containing, for example, hydrofluoric acid (HF) and nitric acid (NHO₃).

Specific embodiments of the present invention are described next.

### 1. Manufacturing a decorative article

### (Embodiment 1)

A decorative article (hands for a wristwatch) was manufactured by applying surface processing as described below.

First, a base material having the shape of hands for a wristwatch was manufactured by casting using stainless steel (SUS 444), and then after cutting at the necessary places a mirror finish was applied by diamond polishing. This base material was then cleaned. The base material was cleaned by alkali electrolytic degreasing for 30 seconds followed by alkali dipping degreasing for 30 seconds. Then followed neutralization for 10 seconds, water wash for 10 seconds, and a demineralized water wash for 10 seconds.

A film formed from a Au-Pd-Fe-In alloy (92.1 wt% Au, 1.87 wt% Pd, 1.68 wt% Fe, 4.35 wt% In) was then formed on the cleaned surface of the base material (the side processed to a mirror finish). The film was formed by vacuum deposition as described below.

First, the base material was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr, the target was dissolved and vapor deposited by resistance heating using a tungsten board to form a film composed of a Au-Pd-Fe-In alloy and obtain the decorative article. The targets were a Au-Pd-Fe alloy target and an In target. The average thickness of the formed film was 0.5 µm. The film thickness was measured by the JIS H 5821 microscope cross-sectional test method.

### (Embodiment 2)

Except for using a Cu-Zn alloy (alloy composition: 60 wt% Cu, 40 wt% Zn) for the base material, a decorative article was manufactured in the same way as in embodiment 1.

### (Embodiment 3)

A decorative article (wristwatch case (body)) was manufactured by applying surface processing as described below.

A Ti base material in the shape of a wristwatch case (body) was manufactured by metal injection molding (MIM).

The Ti base material was manufactured as follows.

First, Ti powder with a 52 µm average grain size manufactured by a gas atomization method was prepared. A material containing 75 vol% of this Ti powder, 8 vol% polyethylene, 7 vol% polypropylene, and 10 vol% paraffin wax was kneaded. A kneader was used to knead this material. The material temperature during kneading was 60°C. The kneaded material was then ground and graded to obtain pellets with an average grain size of 3 mm. Using these pellets in an injecting molding machine, moldings in the shape of the wristwatch case were manufactured by metal injection molding (MIM). The moldings were made with consideration for shrinkage in the debindering process and during sintering. Molding conditions during injection molding were a 40°C mold temperature, 80 kgf/cm² injection pressure, 20 second injection time, and 40 second cooling time. Next, a debindering process was applied to the molding using a degreasing oven to obtain a degreased molding. For the debindering process the molding was left in a 1x10⁻³ Torr argon gas atmosphere at 80°C for 1 hour, and then raised to 400°C at 10°C/hour. Sample weight was measured during the heat treatment to find the point at which weight loss ended as the debindering completion point. The resulting degreased molding was then sintered in a sintering oven to obtain the base material. Sintering was accomplished by heating in a 1x10⁻⁵ to 1x10⁻⁶ Torr argon gas atmosphere at 900 to 1100°C for 6 hours.

The base material thus obtained was then cut in the necessary places and polished, and the base material was then cleaned. The base material was cleaned by alkali electrolytic degreasing for 30 seconds followed by alkali dipping degreasing for 30 seconds. Then followed neutralization for 10 seconds, water wash for 10 seconds, and a demineralized water wash for 10 seconds.

A film consisting of a Au-Pd-Fe-In alloy (90.1 wt% Au, 1.80 wt% Pd, 1.53 wt% Fe, 6.57 wt% In) was then formed on the cleaned surface of the base material.

The film was formed by vacuum deposition as described below.

First, the base material was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr, the target was dissolved and vapor deposited by resistance heating using a tungsten board to form a film composed of a Au-Pd-Fe-In alloy and obtain the decorative article. The targets were a Au-Pd-Fe alloy target and an In target. The average thickness of the formed film was 0.5 µm. The film thickness was measured by the JIS H 5821 microscope cross-sectional test method.

### (Embodiment 4)

Except for using a Au-Pd-Fe alloy target, an In target, and an Sn target as the targets for vacuum deposition, and forming a film of an alloy composition containing 95.0 wt% Au, 1.96 wt% Pd, 0.54 wt% In, 0.75 wt% Sn, and 1.75 wt% Fe, a decorative article was manufactured in the same way as in embodiment 2. The average thickness of the formed film was 0.5 µm. The film thickness was measured by the JIS H 5821 microscope cross-sectional test method.

### (Embodiment 5)

A decorative article (wristwatch case (body)) was manufactured by applying surface processing as described below.

First, a base material in the shape of a wristwatch case (body) was manufactured by casting using stainless steel (SUS 444), and then after cutting at the necessary places a mirror finish was applied by diamond polishing. This base material was then cleaned. The base material was cleaned by alkali dipping degreasing for 30 seconds, followed by neutralization for 10 seconds, water wash for 10 seconds, and a demineralized water wash for 10 seconds.

A primary coat of Au-Fe was then formed on the surface of the mirror-finished side of this base material. The primary coat was formed by wet plating using a 40°C bath temperature and 1.0 A/dm² current density for 12 minutes. The average thickness of the primary coat formed this way was 1.0 µm. The base material on which the primary coat was formed was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A film formed from a Au-Pd-Fe-In alloy (88.2 wt% Au, 3.05 wt% Pd, 2.65 wt% Fe, 6.10 wt% In) was then formed on the cleaned surface of the primary coat.

The film was formed by vacuum deposition as described below.

First, the base material on which the primary coat was formed was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr, the target was dissolved and vapor deposited by resistance heating using a tungsten board to form a film composed of a Au-Pd-Fe-In alloy and obtain the decorative article. The targets were a Au-Pd-Fe alloy target and an In target. The average thickness of the formed film was 0.5 µm.

The film thickness was measured by the JIS H 5821 microscope cross-sectional test method.

### (Embodiment 6)

A decorative article (wristwatch dial) was manufactured by applying surface processing as described below.

First, a base material in the shape of a wristwatch dial was manufactured by casting using a Cu-Zn alloy (alloy composition: 60 wt% Cu, 40 wt% Zn), and then cut at the necessary places and polished. This base material was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A primary coat of Au-Fe was then formed on the surface of this base material. The primary coat was formed by wet plating using a 40°C bath temperature and 1.0 A/dm² current density for 24 minutes. The average thickness of the primary coat formed this way was 2.0 µm. The base material on which the primary coat was formed was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A film formed from a Au-Pd-Fe-In alloy (91.5 wt% Au, 2.15 wt% Pd, 1.74 wt% Fe, 4.61 wt% In) was then formed on the cleaned surface of the primary coat.

The film was formed by vacuum deposition as described below.

First, the base material on which the primary coat was formed was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr, the target was dissolved and vapor deposited by resistance heating using a tungsten board to form a film composed of a Au-Pd-Fe-In alloy and obtain the decorative article. The targets were a Au-Pd-Fe alloy target and an In target. The average thickness of the formed film was 0.5 µm.

The film thickness was measured by the JIS H 5821 microscope cross-sectional test method.

### (Embodiment 7)

A decorative article (wristwatch case (back cover)) was manufactured by applying surface processing as described below.

A Ti base material in the shape of a wristwatch case (back cover) was manufactured by metal injection molding (MIM).

The Ti base material was manufactured as follows.

First, Ti powder with a 52 µm average grain size manufactured by a gas atomization method was prepared. A material containing 75 vol% of this Ti powder, 8 vol% polyethylene, 7 vol% polypropylene, and 10 vol% paraffin wax was kneaded. A kneader was used to knead this material. The material temperature during kneading was 60°C. The kneaded material was then ground and graded to obtain pellets with an average grain size of 3 mm. Using these pellets in an injecting molding machine, moldings in the shape of the wristwatch case were manufactured by metal injection molding (MIM). The moldings were made with consideration for shrinkage in the debindering process and during sintering. Molding conditions during injection molding were a 40°C mold temperature, 80 kgf/cm² injection pressure, 20 second injection time, and 40 second cooling time. Next, a debindering process was applied to the molding using a degreasing oven to obtain a degreased molding. For the debindering process the molding was left in a 1x10⁻³ Torr argon gas atmosphere at 80°C for 1 hour, and then raised to 400°C at 10°C/hour. Sample weight was measured during the heat treatment to find the point at which weight loss ended as the debindering completion point. The resulting degreased molding was then sintered in a sintering oven to obtain the base material. Sintering was accomplished by heating in a 1x10⁻⁵ to 1x10⁻⁶ Torr argon gas atmosphere at 900 to 1100°C for 6 hours.

The base material thus obtained was then cut in the necessary places and polished, and the base material was then cleaned. The base material was cleaned by alkali electrolytic degreasing for 30 seconds followed by alkali dipping degreasing for 30 seconds. Then followed neutralization for 10 seconds, water wash for 10 seconds, and a demineralized water wash for 10 seconds.

A primary coat of Au-Fe was then formed on the surface of this base material. The primary coat was formed by wet plating using a 40°C bath temperature and 1.0 A/dm² current density for 12 minutes. The average thickness of the primary coat formed this way was 1.0 µm. The base material on which the primary coat was formed was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A film formed from a Au-Pd-Fe-In alloy (87.6 wt% Au, 3.12 wt% Pd, 2.23 wt% Fe, 7.05 wt% In) was then formed on the cleaned surface of the primary coat.

The film was formed by vacuum deposition as described below.

First, the base material on which the primary coat was formed was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr, the target was dissolved and vapor deposited by resistance heating using a tungsten board to form a film composed of a Au-Pd-Fe-In alloy and obtain the decorative article. The targets were a Au-Pd-Fe alloy target and an In target. The average thickness of the formed film was 0.5 µm.

The film thickness was measured by the JIS H 5821 microscope cross-sectional test method.

### (Embodiment 8)

A decorative article (wristwatch case (body)) was manufactured by applying surface processing as described below.

First, a base material having the shape of a wristwatch case (body) was manufactured by casting using stainless steel (SUS 444), and then after cutting at the necessary places a mirror finish was applied by diamond polishing. This base material was then cleaned. The base material was cleaned by alkali electrolytic dipping degreasing for 30 seconds, followed by neutralization for 10 seconds, water wash for 10 seconds, and a demineralized water wash for 10 seconds.

A primary coat of TiN and a film of a Au-Pd-Fe-In alloy (95.7 wt% Au, 2.34 wt% Pd, 0.17 wt% Fe, 1.79 wt% In) was then formed on the surface of the mirror-finished side of this base material as follows.

First, the base material was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr. In this state the Ti inside the chamber was ionized using an electron beam. The argon gas supply was then stopped and was replaced by introducing nitrogen gas to the chamber to form a primary coat of TiN by an ARE (activated reactive evaporation) method (Vickers hardness: 2000). The nitrogen gas flow during primary coat formation was 160 ml/mm at a pressure of 5x10⁻⁴ Torr.

The target was then dissolved and vapor deposited (vacuum deposited) by resistance heating using a tungsten board to form a film composed of a Au-Pd-Fe-In alloy on the surface of the primary coat and obtain the decorative article. The targets were a Au-Pd-Fe alloy target and an In target.

The average thickness of the formed primary coat and film was 1.0 µm and 0.5 µm, respectively. The thickness of the primary coat and film was measured by the JIS H 5821 microscope cross-sectional test method.

### (Embodiment 9)

A decorative article (wristwatch dial) was manufactured by applying surface processing as described below.

First, a base material in the shape of a wristwatch dial was manufactured by casting using a Cu-Zn alloy (alloy composition: 60 wt% Cu, 40 wt% Zn), and then cut at the necessary places and polished. This base material was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A primary coat of TiN and a film of a Au-Pd-Fe-In alloy (94.0 wt% Au, 0.15 wt% Pd, 3.49 wt% Fe, 2.36 wt% In) was then formed on the surface of this base material as follows.

First, the base material was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr. In this state the Ti inside the chamber was ionized using an electron beam. The argon gas supply was then stopped and was replaced by introducing nitrogen gas to the chamber to form a primary coat of TiN by an ARE method (Vickers hardness: 2000). The nitrogen gas flow during primary coat formation was 160 ml/mm at a pressure of 5x10⁻⁴ Torr.

The target was then dissolved and vapor deposited (vacuum deposited) by resistance heating using a tungsten board to form a film composed of a Au-Pd-Fe-In alloy on the surface of the primary coat and obtain the decorative article. The targets were a Au-Pd-Fe alloy target and an In target.

The average thickness of the formed primary coat and film was 1.0 µm and 0.5 µm, respectively. The thickness of the primary coat and film was measured by the JIS H 5821 microscope cross-sectional test method.

### (Embodiment 10)

A decorative article (wristwatch case (back cover)) was manufactured by applying surface processing as described below.

A Ti base material in the shape of a wristwatch case (back cover) was manufactured by metal injection molding (MIM).

The Ti base material was manufactured as follows.

First, Ti powder with a 52 µm average grain size manufactured by a gas atomization method was prepared. A material containing 75 vol% of this Ti powder, 8 vol% polyethylene, 7 vol% polypropylene, and 10 vol% paraffin wax was kneaded. A kneader was used to knead this material. The material temperature during kneading was 60°C. The kneaded material was then ground and graded to obtain pellets with an average grain size of 3 mm. Using these pellets in an injecting molding machine, moldings in the shape of the wristwatch case were manufactured by metal injection molding (MIM). The moldings were made with consideration for shrinkage in the debindering process and during sintering. Molding conditions during injection molding were a 40°C mold temperature, 80 kgf/cm² injection pressure, 20 second injection time, and 40 second cooling time. Next, a debindering process was applied to the molding using a degreasing oven to obtain a degreased molding. For the debindering process the molding was left in a 1x10⁻³ Torr argon gas atmosphere at 80°C for 1 hour, and then raised to 400°C at 10°C/hour. Sample weight was measured during the heat treatment to find the point at which weight loss ended as the debindering completion point. The resulting degreased molding was then sintered in a sintering oven to obtain the base material. Sintering was accomplished by heating in a 1x10⁻⁵ to 1x10⁻⁶ Torr argon gas atmosphere at 900 to 1100°C for 6 hours.

The base material thus obtained was then cut in the necessary places and polished, and the base material was then cleaned. The base material was cleaned by alkali electrolytic degreasing for 30 seconds followed by alkali dipping degreasing for 30 seconds. Then followed neutralization for 10 seconds, water wash for 10 seconds, and a demineralized water wash for 10 seconds.

A primary coat of TiN and a film of a Au-Pd-Fe-In alloy (96.2 wt% Au, 1.94 wt% Pd, 1.72 wt% Fe, 0.14 wt% In) was then formed on the surface of this base material as follows.

First, the base material was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr. In this state the Ti inside the chamber was ionized using an electron beam. The argon gas supply was then stopped and was replaced by introducing nitrogen gas to the chamber to form a primary coat of TiN by an ARE method (Vickers hardness: 2000). The nitrogen gas flow during primary coat formation was 160 ml/mm at a pressure of 5x10⁻⁴ Torr.

The target was then dissolved and vapor deposited (vacuum deposited) by resistance heating using a tungsten board to form a film composed of a Au-Pd-Fe-In alloy on the surface of the primary coat and obtain the decorative article. The targets were a Au-Pd-Fe alloy target and an In target.

The average thickness of the formed primary coat and film was 1.0 µm and 0.5 µm, respectively. The thickness of the primary coat and film was measured by the JIS H 5821 microscope cross-sectional test method.

### (Embodiment 11)

A decorative article (wristwatch case (body)) was manufactured by applying surface processing as described below.

First, a base material having the shape of a wristwatch case (body) was manufactured by casting using stainless steel (SUS 444), and then after cutting at the necessary places a mirror finish was applied by diamond polishing. This base material was then cleaned. The base material was cleaned by alkali electrolytic dipping degreasing for 30 seconds, followed by neutralization for 10 seconds, water wash for 10 seconds, and a demineralized water wash for 10 seconds.

A first primary coat of Au-Fe was then formed on the surface of the mirror-finished side of this base material. The first primary coat was formed by wet plating using a 40°C bath temperature and 1.0 A/dm² current density for 12 minutes. The average thickness of the first primary coat formed this way was 1 µm. The base material on which the first primary coat was formed was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A second primary coat of ZrN and a film of a Au-Pd-Fe-In alloy (88.2 wt% Au, 9.25 wt% Pd, 1.32 wt% Fe, 1.23 wt% In) was then formed on the surface of the cleaned first primary coat as follows.

First, the base material on which the first primary coat was formed was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr. In this state the Zr inside the chamber was ionized using an electron beam. The argon gas supply was then stopped and was replaced by introducing nitrogen gas to the chamber to form a primary coat of ZrN by an ARE method (Vickers hardness: 2000). The nitrogen gas flow during second primary coat formation was 160 ml/mm at a pressure of 5x10⁻⁴ Torr.

The target was then dissolved and vapor deposited (vacuum deposited) by resistance heating using a tungsten board to form a film composed of a Au-Pd-Fe-In alloy on the surface of the second primary coat and obtain the decorative article. The targets were a Au-Pd-Fe alloy target and an In target.

The average thickness of the formed second primary coat and film was 1.0 µm and 0.5 µm, respectively.

### (Embodiment 11)

A decorative article (wristwatch dial) was manufactured by applying surface processing as described below.

First, a base material in the shape of a wristwatch dial was manufactured by casting using a Cu-Zn alloy (alloy composition: 60 wt% Cu, 40 wt% Zn), and then cut at the necessary places and polished. This base material was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A first primary coat of Au-Fe was then formed on the surface of the base material. The first primary coat was formed by wet plating using a 40°C bath temperature and 1.0 A/dm² current density for 24 minutes. The average thickness of the first primary coat formed this way was 2.0 µm. The base material on which the first primary coat was formed was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A second primary coat of CrN and a film of a Au-Pd-Fe-In alloy (88.7 wt% Au, 1.93 wt% Pd, 7.01 wt% Fe, 2.36 wt% In) was then formed on the surface of the cleaned first primary coat as follows.

First, the base material on which the first primary coat was formed was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr. In this state the Cr inside the chamber was ionized using an electron beam. The argon gas supply was then stopped and was replaced by introducing nitrogen gas to the chamber to form a primary coat of CrN by an ARE method (Vickers hardness: 2000). The nitrogen gas flow during second primary coat formation was 160 ml/mm at a pressure of 5x10⁻⁴ Torr.

The target was then dissolved and vapor deposited (vacuum deposited) by resistance heating using a tungsten board to form a film composed of a Au-Pd-Fe-In alloy on the surface of the second primary coat and obtain the decorative article. The targets were a Au-Pd-Fe alloy target and an In target.

The average thickness of the formed second primary coat and film was 10 µm and 1.0 µm, respectively.

### (Embodiment 13)

A decorative article (wristwatch case (back cover)) was manufactured by applying surface processing as described below.

First, a base material of aluminum having the shape of a wristwatch case was made by casting, then cut in the required places and polished. The surface of the base material was then embossed by polishing with #180 emery. The embossed base material was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A first primary coat of Ti, a second primary coat of TiN, and a film of a Au-Pd-Fe-In alloy (87.6 wt% Au, 1.76 wt% Pd, 1.55 wt% Fe, 9.09 wt% In) were then formed on the surface on the embossed side of this base material as follows.

First, the cleaned base material was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr. In this state the Ti inside the chamber was ionized using an electron beam and deposited on the base material surface (ion plating) to form the first primary coat. The argon gas supply was then stopped and was replaced by introducing nitrogen gas to the chamber to form a second primary coat of TiN by an ARE method (Vickers hardness: 2000). The nitrogen gas flow during second primary coat formation was 160 ml/mm at a pressure of 5x10⁻⁴ Torr.

The target was then dissolved and vapor deposited (vacuum deposited) by resistance heating using a tungsten board to form a film composed of a Au-Pd-Fe-In alloy on the surface of the second primary coat and obtain the decorative article. The targets were a Au-Pd-Fe alloy target and an In target.

The average thickness of the formed first primary coat, second primary coat, and film was 1.0 µm, 0.5 µm, and 0.5 µm, respectively.

### (Embodiment 14)

A decorative article (wristwatch case (back cover)) was manufactured by applying surface processing as described below.

First, a base material of Ni having the shape of a wristwatch case was made by casting, then cut in the required places and polished. The surface of the base material was then embossed by polishing with #180 emery.

A first primary coat of Ni was then formed on the surface of the embossed base material. The first primary coat was formed by wet plating using a 60°C bath temperature and 3 A/dm² current density for 10 minutes. The average thickness of the first primary coat formed this way was 5.0 µm. The base material on which the first primary coat was formed was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A second primary coat of Pd was then formed on the surface of the first primary coat. The second primary coat was formed by wet plating using a 48°C bath temperature and 0.4 A/dm² current density for 18 minutes. The average thickness of the second primary coat formed this way was 2.0 µm. The base material on which the first primary coat and second primary coat were formed was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

An Au-Pd-Fe-In alloy film (91.3 wt% Au, 1.96 wt% Pd, 1.70 wt% Fe, 5.04 wt% In) was then formed on the surface of the second primary coat.

The film was formed by vacuum deposition as described below.

First, the base material on which the first primary coat and second primary coat were formed was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min.

The chamber was then vented (reduced) to 2x10⁻⁶ Torr, the target was dissolved and vapor deposited by resistance heating using a tungsten board to form a film composed of a Au-Pd-Fe-In alloy and obtain the decorative article. The targets were a Au-Pd-Fe alloy target and an In target. The average thickness of the formed film was 0.5 µm.

A decorative article (wristwatch case (back cover)) was manufactured by applying surface processing as described below.

First, a base material of stainless steel (SUS 444) having the shape of a wristwatch case (back cover) was made by casting, then cut in the required places and polished. The surface of the base material was then embossed by polishing with #180 emery.

A first primary coat of Au-Fe was then formed on the surface of the embossed base material. The first primary coat was formed by wet plating using a 40°C bath temperature and 1.0 A/dm² current density for 12 minutes. The average thickness of the first primary coat formed this way was 1.0 µm. The base material on which the first primary coat was formed was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A second primary coat of Ti, a third primary coat of TiN, and a Au-Pd-Fe-In alloy film (90.2 wt% Au, 2.36 wt% Pd, 2.11 wt% Fe, 5.33 wt% In) were then formed on the surface of the first primary coat by a method such as described below.

First, the base material on which the first primary coat was formed was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr. In this state the Ti inside the chamber was ionized using an electron beam and deposited on the surface of the first primary coat (ion plating) to form the second primary coat.

The argon gas supply was then stopped and was replaced by introducing nitrogen gas to the chamber to form a third primary coat of TiN by an ARE method (Vickers hardness: 2000). The nitrogen gas flow during third primary coat formation was 160 ml/mm at a pressure of 5x10⁻⁴ Torr.

The target was then dissolved and vapor deposited (vacuum deposited) by resistance heating using a tungsten board to form a film composed of a Au-Pd-Fe-In alloy on the surface of the third primary coat and obtain the decorative article. The targets were a Au-Pd-Fe alloy target and an In target.

The average thickness of the formed second primary coat, third primary coat, and film was 1.0 µm, 1.0 µm, and 0.5 µm, respectively.

### (Embodiments 16, 17)

Decorative articles were manufactured in the same way as in the fifteenth embodiment except for changing the alloy composition of the formed film as shown in Table. 2 by changing the composition of the Au-Pd-Fe-In alloy used as one of the targets.

### (Embodiment 18)

A decorative article (wristwatch case (back cover)) was manufactured by applying surface processing as described below.

First, a base material having the shape of a wristwatch case (back cover) was manufactured by casting using a Cu-Zn alloy (alloy composition: 60 wt% Cu, 40 wt% Zn), then cut in the required places and polished. The surface of the base material was then satinized. Satinizing was done by spraying the base material surface with glass beads at a pressure of 2 kg/cm². The satinized base material was then cleaned. The base material was cleaned first by alkali dipping degreasing for 30 seconds followed by neutralization for 10 seconds, water wash for 10 seconds, and a demineralized water wash for 10 seconds.

A first primary coat of Cu was then formed on the surface of the satinized base material. The first primary coat was formed by wet plating using a 30°C bath temperature and 3.0 A/dm² current density for 10 minutes. The average thickness of the first primary coat formed this way was 10 µm.

A second primary coat of Pd was then formed on the surface of the first primary coat. The second primary coat was formed by wet plating using a 48°C bath temperature and 0.4 A/dm² current density for 18 minutes. The average thickness of the second primary coat formed this way was 2.0 µm. The base material on which the first primary coat and second primary coat were formed was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A third primary coat of TiN, and a Au-Pd-Fe-In alloy film (89.3 wt% Au, 2.11 wt% Pd, 2.03 wt% Fe, 6.56 wt% In) were then formed on the surface of the base material on which the first primary coat and second primary coat were built up as described below.

First, the base material on which the first primary coat and second primary coat were built up was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min.

The chamber was then vented (reduced) to 2x10⁻⁶ Torr. In this state the Ti inside the chamber was ionized using an electron beam. Next, the argon gas supply was stopped and was replaced by introducing nitrogen gas to the chamber to form a third primary coat of TiN by an ARE method (Vickers hardness: 2000). The nitrogen gas flow during third primary coat formation was 160 ml/mm at a pressure of 5x10⁻⁴ Torr.

The target was then dissolved and vapor deposited (vacuum deposited) by resistance heating using a tungsten board to form a film composed of a Au-Pd-Fe-In alloy on the surface of the third primary coat and obtain the decorative article. The targets were a Au-Pd-Fe alloy target and an In target.

The average thickness of the formed third primary coat and film was 0.5 µm and 0.5 µm, respectively.

### (Embodiments 19, 20)

Decorative articles were manufactured in the same way as in the eighteenth embodiment except for changing the alloy composition of the formed film as shown in Table 2 by changing the composition of the Au-Pd-Fe-In alloy used as one of the targets.

A decorative article (wristwatch case (back cover)) was manufactured by applying surface processing as described below.

First, a base material of stainless steel (SUS 444) having the shape of a wristwatch case (back cover) was made by casting, then cut in the required places and polished. The surface of the base material was then embossed by polishing with #180 emery. The embossed base material was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A first primary coat of TiN, a second primary coat of TiCN, a third primary coat of TiCNO, and a Au-Pd-Fe-In alloy film (91.7 wt% Au, 3.16 wt% Pd, 1.28 wt% Fe, 3.86 wt% In) were then formed on the surface on the embossed side of the base material by a method such as described below.

First, the cleaned base material was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr. In this state the Ti inside the chamber was ionized using an electron beam. The argon gas supply was then stopped and was replaced by introducing nitrogen gas to the chamber to form a first primary coat of TiN by an ARE method (Vickers hardness: 2000). The nitrogen gas flow during third primary coat formation was 160 ml/mm at a pressure of 5x10⁻⁴ Torr.

A C₂H₂ gas was then introduced to the chamber from this state, and a second primary coat of TiCN was formed by an ARE method. During second primary coat formation nitrogen gas flow was 186 ml/mm and C₂H₂ gas flow was 20 ml/mm at a pressure of 5x10⁻⁴ Torr.

O₂ gas was then introduced to the chamber from this state to form the third primary coat of TiCNO by an ARE method. During third primary coat formation nitrogen gas flow was 9 ml/mm, C₂H₂ gas flow was 79 ml/mm, and O₂ gas flow was 31 ml/mm at a pressure of 5x10⁻⁴ Torr.

The target was then dissolved and vapor deposited (vacuum deposited) by resistance heating using a tungsten board to form a film composed of a Au-Pd-Fe-In alloy on the surface of the third primary coat and obtain the decorative article. The targets were a Au-Pd-Fe alloy target and an In target.

The average thickness of the formed first primary coat, second primary coat, third primary coat, and film was 0.5 µm, 0.3 µm, 0.2 µm , and 0.5 µm, respectively

### (Embodiment 22)

A decorative article (wristwatch case (back cover)) was manufactured by applying surface processing as described below.

First, a base material having the shape of a wristwatch case (back cover) was manufactured by casting using a Cu-Zn alloy (alloy composition: 60 wt% Cu, 40 wt% Zn), then cut in the required places and polished. The surface of the base material was then satinized. Satinizing was done by spraying the base material surface with glass beads at a pressure of 2 kg/cm². The satinized base material was then cleaned. The base material was cleaned first by alkali dipping degreasing for 30 seconds followed by neutralization for 10 seconds, water wash for 10 seconds, and a demineralized water wash for 10 seconds.

A first primary coat of Cu was then formed on the surface of the satinized base material. The first primary coat was formed by wet plating using a 30°C bath temperature and 3.0 A/dm² current density for 5 minutes. The average thickness of the first primary coat formed this way was 5.0 µm.

A second primary coat of Cu-Sn was then formed on the surface of the first primary coat. The second primary coat was formed by wet plating using a 45°C bath temperature and 2 A/dm² current density for 3 minutes. The average thickness of the second primary coat formed this way was 1.5 µm.

A third primary coat of Pd was then formed on the surface of the second primary coat. The third primary coat was formed by wet plating using a 48°C bath temperature and 0.4 A/dm² current density for 18 minutes. The average thickness of the third primary coat formed this way was 2.0 µm. The base material on which the first to third primary coats were built up was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A Au-Pd-Fe-In alloy film (91.9 wt% Au, 2.05 wt% Pd, 1.85 wt% Fe, 4.2 wt% In) was then formed on the surface of the washed third primary coat.

The film was formed by vacuum deposition as described below.

First, the base material on which the first to third primary coats were built up was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr, and in this state the target was dissolved and vapor deposited by resistance heating using a tungsten board to form a film composed of a Au-Pd-Fe-In alloy and obtain the decorative article. The targets were a Au-Pd-Fe alloy target and an In target. The average thickness of the formed film was 0.5 µm.

### (Embodiment 23)

A decorative article was manufactured in the same way as in the twenty-second embodiment except for removing part of the film formed on the surface of the third primary coat as described below.

First, a mask was formed to a specific shape on part of the surface of the film. The mask was formed by brushing on a rubber resin to cover part of the film surface, and was then dried for 30 minutes at 180 to 200°C. The average thickness of the mask thus formed was 500 µm.

The film was then removed in the parts not covered by the mask. The film was removed by dipping in a liquid state stripping agent. An aqueous solution containing 50 g/liter potassium cyanide was used as the stripping agent. The temperature of the stripping agent and dipping time in the stripping agent in this process were 30°C and 10 minutes, respectively. Ultrasonic vibration at 28 kHz was also applied to the stripping agent during this process.

The mask was then removed by dipping in a mask removal agent consisting of a halogen compound solvent and a ketone solvent. The temperature of the mask removal agent and dipping time in the mask removal agent in this process were 30°C and 30 minutes, respectively. Ultrasonic vibration at 28 kHz was also applied to the mask removal agent during this process.

Except for using a Au-Pd-Fe alloy target, an In target, and an Sn target as the targets for vacuum deposition, and forming a film of an alloy composition containing 92.3 wt% Au, 2.03 wt% Pd, 1.13 wt% Fe, 0.58 wt% Sn, and 3.96 wt% In, a decorative article was manufactured in the same way as in embodiment 22. The average thickness of the formed film was 0.5 µm. The film thickness was measured by the JIS H 5821 microscope cross-sectional test method.

### (Comparison 1)

A decorative article (wristwatch case (back cover)) was manufactured by applying surface processing as described below.

First, a base material in the shape of a wristwatch case (back cover) was manufactured by casting using a Cu-Zn alloy (alloy composition: 60 wt% Cu, 40 wt% Zn), and then cut at the necessary places and polished. This base material was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A film formed from a Au-Pd-Fe alloy (96.3 wt% Au, 2.01 wt% Pd, 1.69 wt% Fe) was then formed on the cleaned surface of the base material.

The film was formed by vacuum deposition as described below.

First, the base material was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr, the target was dissolved and vapor deposited by resistance heating in this state using a tungsten board to form a film composed of a Au-Pd-Fe alloy and obtain the decorative article. The target was a Au-Pd-Fe alloy target. The average thickness of the formed film was 1.0 µm. The film thickness was measured by the JIS H 5821 microscope cross-sectional test method.

### (Comparison 2)

A decorative article was manufactured in the same was as in the above comparison 1 except that the film formed on the surface of the base material was made from a Au-Pd-In alloy (93.1 wt% Au, 4.13 wt% Pd, 2.77 wt% In). The target was a Au-Pd-In alloy target.

### (Comparison 3)

A decorative article was manufactured in the same was as in the above comparison 1 except that the film formed on the surface of the base material was made from a Au-Fe-In alloy (93.0 wt% Au, 2.88 wt% Fe, 4.12 wt% In). The target was a Au-Fe-In alloy target.

### (Comparison 4)

A decorative article was manufactured in the same was as in the above comparison 1 except that the film formed on the surface of the base material was made from a Au-Pd-Fe-In alloy (83.7 wt% Au, 11.1 wt% Pd, 0.74 wt% Fe, 4.46 wt% In). The target was a Au-Pd-Fe-In alloy target.

### (Comparison 5)

A decorative article was manufactured in the same was as in the above comparison 1 except that the film formed on the surface of the base material was made from a Au-Pd-Fe-In alloy (85.6 wt% Au, 1.24 wt% Pd, 9.5 wt% Fe, 3.66 wt% In). The target was a Au-Pd-Fe-In alloy target.

### (Comparison 6)

A decorative article was manufactured in the same was as in the above comparison 1 except that the film formed on the surface of the base material was made from a Au-Pd-Fe-In alloy (85.4 wt% Au, 1.25 wt% Pd, 1.15 wt% Fe, 12.2 wt% In). The target was a Au-Pd-Fe-In alloy target.

### (Comparison 7)

A decorative article (wristwatch case (back cover)) was manufactured by applying surface processing as described below.

First, a base material in the shape of a wristwatch case (back cover) was manufactured by casting using a Cu-Zn alloy (alloy composition: 60 wt% Cu, 40 wt% Zn), and then cut at the necessary places and polished. This base material was then cleaned. Cleaning was done by alkali electrolytic degreasing for 30 seconds followed by alkali dipping degreasing for 30 seconds. Then followed neutralization for 10 seconds, water wash for 10 seconds, and a demineralized water wash for 10 seconds.

A film formed from a Au-Ag-Cu alloy (58.5 wt% Au, 24.0 wt% Ag, 17.5 wt% Cu) was then formed on the cleaned surface of the base material.

The film was formed by vacuum deposition as described below.

First, the base material was fixed in the chamber and then, while preheating the chamber, the chamber pressure was vented (reduced) to 2x10⁻⁵ Torr. The chamber was then further vented (reduced) to 2x10⁻⁶ Torr and a bombarding process run for 5 minutes with an argon gas flow of 470 ml/min. The chamber was then vented (reduced) to 2x10⁻⁶ Torr, the target was dissolved and vapor deposited by resistance heating in this state using a tungsten board to form a film composed of a Au-Ag-Cu alloy and obtain the decorative article. The target was a Au-Ag-Cu alloy target. The average thickness of the formed film was 1.0 µm. The film thickness was measured by the JIS H 5821 microscope cross-sectional test method.

The conditions used in the surface processing methods in each of the embodiments and comparisons are shown in Table 1, Table 2, and Table 3.
[Table 1]
[Table 2]
[Table 3]

### 2. Evaluating decorative article appearance

The color tone of the decorative articles manufactured in each of the embodiments and comparisons described above was measured using a spectrophotometer (Minolta, CM-2022) and evaluated according to the following standards.
* Acceptable (○): if in the L*a*b* color chart defined in JIS Z8729 a* = -3.0 to 2.0 and b* = 19 to 25.
* Unacceptable (X): if in the L*a*b* color chart defined in JIS Z8729 a* = -3.0 to 2.0 but b* is not in the range of 19 to 25.

The light source of the spectrophotometer was D₆₅ defined in JIS Z8720; measurements were taken at a 2° viewing angle.

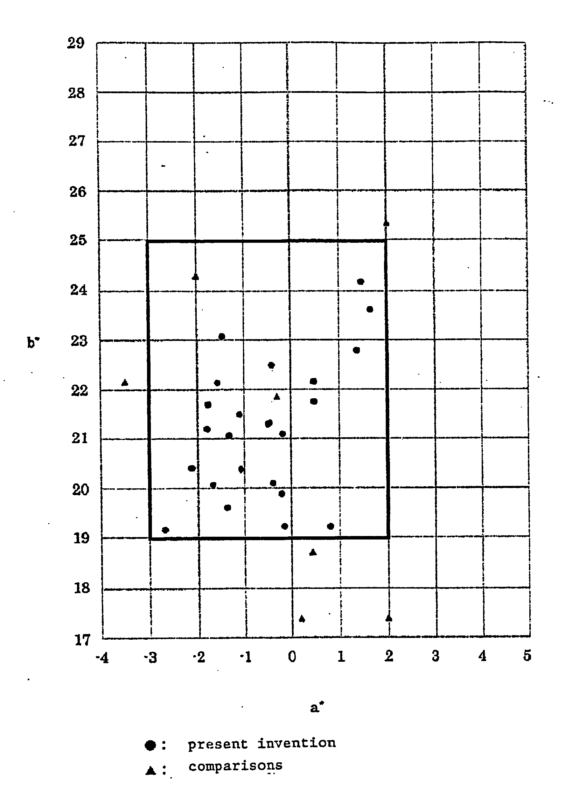

The color chart obtained from these measurements is shown in Fig. 6. The results from decorative articles according to the present invention (embodiments 1 to 24) are denoted with a solid bullet (•) in Fig. 6, and decorative articles from the comparisons (comparisons 1 to 7) are denoted with a solid triangle (▲).

### 3. Long-term stability evaluation of the film

The color tone of the decorative articles manufactured in each of the embodiments and comparisons described above was measured using a spectrophotometer (Minolta, CM-2022) and evaluated according to the above standards after storage for 90 days at normal temperature (25°C), normal pressure, and 70% humidity.

### 4. Oxidation resistance evaluation of the decorative articles

The color tone of the decorative articles manufactured in each of the embodiments and comparisons described above was measured using a spectrophotometer (Minolta, CM-2022) and evaluated according to the above standards after exposure to a normal pressure atmosphere at 200°C for 8 hours.

### 5. Chemical resistance evaluation of the decorative articles

Chemical resistance of the decorative articles manufactured in each of the embodiments and comparisons described above was evaluated after an air exposure test as shown below.

Artificial perspiration was placed in a desiccator and left at 40°C for 24 hours. The decorative articles were then placed in the desiccator and left at 40°C. The decorative articles were placed so that they were not immersed in the artificial perspiration. After 24 hours the decorative articles were removed from the desiccator, and the color tone of the film was measured using a spectrophotometer (Minolta, CM-2022) and evaluated according to the above standards.

The results are shown in Table 4.

### [Table 4]

As will be known from Table 4, each of the decorative articles manufactured using the surface processing method of the present invention has a color close to color 1N-14 defined by CEN standard EN 28654, and has an exceptionally beautiful appearance.

Furthermore, the decorative articles manufactured using the surface processing method of the present invention have excellent long-term stability, oxidation resistance, and chemical resistance. It will be known from these results that a decorative article according to the present invention can retain an exceptionally beautiful appearance for a long time. Furthermore, decorative articles having a primary coat that functions as a buffer layer have particularly exceptional corrosion resistance. In addition, decorative articles in which the primary coat in contact with the film is composed of a material containing Pd (embodiments 14, 22, 23, 24) offer particularly exceptional oxidation resistance. This is believed to be because the primary coat made of a material containing Pd effectively prevents the diffusion of constituent materials (particularly Au) in the film.

Furthermore, all of the decorative articles manufactured using the surface processing method of the present invention have an excellent feel free of any sense of coarseness.

Furthermore, a film having the desired composition and characteristics can be easily formed by using a dry plating method using multiple targets of different metal compositions.

By comparison, a decorative article having a film with a color close to color 1N-14 defined by CEN standard EN 28654 cannot be achieved with the surface processing methods of comparisons 1 to 5. Furthermore, the long-term stability, oxidation resistance, and chemical resistance of the decorative articles manufactured using the surface processing methods of comparisons 4, 5, and 6 were particularly poor.

Furthermore, the decorative article manufactured using the surface processing methods of comparisons 6 and 7 were close to color 1N-14 defined by CEN standard EN 28654, but the long-term stability, oxidation resistance, and chemical resistance were poor.

### [Effects of the invention]

As described above, decorative articles and timepieces having a whitish gold color and exceptionally beautiful appearance can be manufactured easily and quickly by means of the present invention.

In particular, decorative articles and timepieces having a color close to color 1N-14 defined by CEN standard EN 28654 can be manufactured easily and quickly.

Furthermore, decorative articles and timepieces according to the present invention have excellent long-term stability, oxidation resistance, and chemical resistance, and can retain an exceptionally beautiful appearance for a long time.

Furthermore, a film having the desired composition and characteristics can be easily formed by using a dry plating method using multiple targets of different metal compositions.

Furthermore, decorative articles having a complicated shape can be easily manufactured by, for example, selecting the constituent materials of the base material, and the weight and manufacturing cost of the decorative articles and timepieces can be reduced.

## Claims

1. A surface processing method for a decorative article, comprising a step for forming a film composed of a Au-Pd-Fe-In alloy containing 0.1 to 10 wt% Pd, 0.1 to 8 wt% Fe, 0.1 to 10.0 wt% In, and optionally a total content of 1.5 wt% or less of one or more of Cu, Zn, Ni, Mg, Cr, Mn, Mo, Nb, W, Al, Ag, V, Zr, Sn and Pt, the balance of the alloy being made up of Au, wherein the film is formed by a dry plating method on at least part of a base material surface.

2. A surface processing method for a decorative article as claimed in claim 1, comprising a further step for applying a cleaning process to at least part of the base material surface before the film forming step.

3. A surface processing method for a decorative article, comprising a step for forming a primary coat with at least one layer on at least part of a base material surface, and
a step for forming on this primary coat by a dry plating method a film composed of a Au-Pd-Fe-In alloy containing 0,1 to 10 wt% Pd, 0.1 to 8 wt% Fe, 0.1 to 10.0 wt% In, and optionally a total content of 1.5 wt% or less of one or more of Cu, Zn, Ni, Mg, Cr, Mn, Mo, Nb, W, Al, Ag, V, Zr, Sn and Pt, the balance of the alloy being made up of Au.

4. A surface processing method for a decorative article as claimed in claim 3, comprising a further step for applying a cleaning process to at least part of the base material surface before the step forming the primary coat.

5. A surface processing method for a decorative article as claimed in claim 3 or 4, comprising a further step for applying a cleaning process to at least part of the primary coat surface before the film forming process.

6. A surface processing method for a decorative article as claimed in any of claims 3 to 5, wherein at least one layer of the primary coat is a buffer layer for buffering the potential difference between one surface side thereof and the other surface side.

7. A surface processing method for a decorative article as claimed in any of claims 3 to 6, wherein at least one layer of the primary coat is a metal nitride layer composed of a material containing a nitride of at least one of the following: Ti, Zr, Hf, Ta, Cr.

8. A surface processing method for a decorative article as claimed in claim 7, wherein the metal nitride layer contacts the film.

9. A surface processing method for a decorative article as claimed in any of claims 3 to 8, wherein at least one layer of the primary coat is a metal layer of or an alloy composed of at least one of the following: Cu, Co, Pd, Au, Ag, In, Sn, Ni, Ti, Zn, Al, Fe, Cr, Pt, Rh, Ru, Ir.

10. A surface processing method for a decorative article as claimed in any of claims 3 to 9, wherein the decorative article has two or more primary coats.

11. A surface processing method for a decorative article as claimed in claim 1, wherein adjacent primary coats are composed of materials containing a common element.

12. A surface processing method for a decorative article as claimed in any of claims 1 to 11, wherein the film is formed by a vacuum deposition method.

13. A surface processing method for a decorative article as claimed in claim 12, wherein the film is formed by a dry plating method using plural targets of different metal compositions.

14. A surface processing method for a decorative article as claimed in claim 13, wherein a Au-Pd-Fe alloy target and an In target are used as the targets.

15. A surface processing method for a decorative article as claimed in any of claims 1 to 14, wherein the film has a color close to color 1N-14 as defined in CEN standard EN 28654.

16. A surface processing method for a decorative article as claimed in any of claims 1 to 15, further comprising a step for masking at least part of the film surface after forming the film;
a step for removing the film in parts not covered by the mask using a stripping agent; and
a step for removing the mask.

17. A decorative article manufactured using a surface processing method for a decorative article as claimed in any of claims 1 to 16.

18. A decorative article comprising a base material and a film covering at least part of the base material, the film being composed of a Au-Pd-Fe-In alloy containing 0.1 to 10 wt% Pd, 0.1 to 8 wt% Fe, 0.1 to 10.0 wt% In, and optionally a total content of 1.5 wt% or less of one or more of Cu, Zn, Ni, Mg, Cr, Mn, Mo, Nb, W, Al, Ag, V, Zr, Sn and Pt, the balance of the alloy being made up of Au.

19. A decorative article as claimed in claim 18, further comprising at least one primary coat between the base material and film.

20. A decorative article as claimed in claim 19, wherein at least one primary coat is a buffer layer for buffering the potential difference between one surface side thereof and the other surface side.

21. A decorative article as claimed in claim 19 or 20, wherein at least one primary coat is a metal nitride layer composed of a material containing a nitride of at least one of the following: Ti, Zr, Hf, Ta, Cr.

22. A decorative article as claimed in any of claims 19 to 21, wherein at least one primary coat is a metal layer or an alloy composed of at least one of the following: Cu, Co, Pd, Au, Ag, In, Sn, Ni, Ti, Zn, Al, Fe, Cr, Pt, Rh, Ru, Ir.

23. A decorative article as claimed in any of claims 19 to 22, wherein the film has a color close to color 1N-14 as defined in CEN standard EN 28654.

24. A decorative article as claimed in any of claims 17 to 23, wherein the decorative article is a case part for a timepiece.

25. A timepiece comprising a decorative article as claimed in any of claims 17 to 24.

## Patentansprüche

1. Oberflächenbearbeitungsverfahren für einen dekorativen Gegenstand, umfassend einen Schritt zum Bilden eines Films, der aus einer Au-Pd-Fe-In-Legierung besteht, die 0,1 bis 10 Gewichtsprozent Pd, 0,1 bis 8 Gewichtsprozent Fe, 0,1 bis 10,0 Gewichtsprozent In und wahlweise einen Gesamtgehalt von 1,5 Gewichtsprozent oder weniger von einem oder mehreren von Cu, Zn, Ni, Mg, Cr, Mn, Mo, Nb, W, Al, Ag, V, Zr, Sn und Pt enthält, wobei der Rest der Legierung aus Au besteht, wobei der Film durch ein Trockenplattierungsverfahren auf mindestens einem Teil einer Basismaterialoberfläche gebildet wird.

2. Oberflächenbearbeitungsverfahren für einen dekorativen Gegenstand nach Anspruch 1, umfassend einen weiteren Schritt zum Ausführen eines Reinigungsprozesses an mindestens einem Teil der Basismaterialoberfläche vor dem Filmbildungsschritt.

3. Oberflächenbearbeitungsverfahren für einen dekorativen Gegenstand, umfassend einen Schritt zum Bilden einer primären Beschichtung mit mindestens einer Schicht auf mindestens einem Teil der Basismaterialoberfläche, und
einen Schritt zum Bilden eines Films, der aus einer Au-Pd-Fe-In-Legierung besteht, die 0,1 bis 10 Gewichtsprozent Pd, 0,1 bis 8 Gewichtsprozent Fe, 0,1 bis 10,0 Gewichtsprozent In und wahlweise einen Gesamtgehalt von 1,5 Gewichtsprozent oder weniger von einem oder mehreren von Cu, Zn, Ni, Mg, Cr, Mn, Mo, Nb, W, Al, Ag, V, Zr, Sn und Pt enthält, wobei der Rest der Legierung aus Au besteht, auf dieser primären Beschichtung durch ein Trockenplattierungsverfahren.

4. Oberflächenbearbeitungsverfahren für einen dekorativen Gegenstand nach Anspruch 3, umfassend einen weiteren Schritt zum Ausführen eines Reinigungsprozesses an mindestens einem Teil der Basismaterialoberfläche vor dem Schritt zum Bilden der primären Beschichtung.

5. Oberflächenbearbeitungsverfahren für einen dekorativen Gegenstand nach Anspruch 3 oder 4, umfassend einen weiteren Schritt zum Ausführen eines Reinigungsprozesses an mindestens einem Teil der primären Beschichtungsoberfläche vor dem Filmbildungsprozess.

6. Oberflächenbearbeitungsverfahren für einen dekorativen Gegenstand nach einem der Ansprüche 3 bis 5, wobei mindestens eine Schicht der primären Beschichtung einer Ausgleichsschicht zum Ausgleichen der möglichen Differenz zwischen ihrer einen Oberflächenseite und ihrer anderen Oberflächenseite ist.

7. Oberflächenbearbeitungsverfahren für einen dekorativen Gegenstand nach einem der Ansprüche 3 bis 6, wobei mindestens eine Schicht der primären Beschichtung eine Metallnitridschicht ist, die aus einem Material besteht, das ein Nitrid von mindestens einem der Folgenden enthält: Ti, Zr, Hf, Ta, Cr.

8. Oberflächenbearbeitungsverfahren für einen dekorativen Gegenstand nach Anspruch 7, wobei die Metallnitridschicht mit dem Film in Kontakt ist.

9. Oberflächenbearbeitungsverfahren für einen dekorativen Gegenstand nach einem der Ansprüche 3 bis 8, wobei mindestens eine Schicht der primären Beschichtung eine Metallschicht von oder eine Legierung bestehend aus mindestens einem der Folgenden ist: Cu, Co, Pd, Au, Ag, In, Sn, Ni, Ti, Zn, Al, Fe, Cr, Pt, Rh, Ru, Ir.

10. Oberflächenbearbeitungsverfahren für einen dekorativen Gegenstand nach einem der Ansprüche 3 bis 9, wobei der dekorative Gegenstand zwei oder mehr primäre Beschichtungen aufweist.

11. Oberflächenbearbeitungsverfahren für einen dekorativen Gegenstand nach Anspruch 1, wobei benachbarte primäre Beschichtungen aus Materialien bestehen, die ein gemeinsames Element enthalten.

12. Oberflächenbearbeitungsverfahren für einen dekorativen Gegenstand nach einem der Ansprüche 1 bis 11, wobei der Film durch ein Vakuumabscheidungsverfahren gebildet wird.

13. Oberflächenbearbeitungsverfahren für einen dekorativen Gegenstand nach Anspruch 12, wobei der Film durch ein Trockenplattierungsverfahren unter Verwendung mehrerer Targets verschiedener Metallzusammensetzungen gebildet wird.

14. Oberflächenbearbeitungsverfahren für einen dekorativen Gegenstand nach Anspruch 13, wobei ein Au-Pd-Fe-Legierung-Target und ein In-Target als Targets verwendet werden.

15. Oberflächenbearbeitungsverfahren für einen dekorativen Gegenstand nach einem der Ansprüche 1 bis 14, wobei der Film eine Farbe nahe der Farbe IN-14 hat, wie im CEN-Standard EN 28654 definiert ist.

16. Oberflächenbearbeitungsverfahren für einen dekorativen Gegenstand nach einem der Ansprüche 1 bis 15, des Weitern umfassend einen Schritt zum Maskieren mindestens eines Teils der Filmoberfläche nach Bildung des Films; einen Schritt zum Entfernen des Films an Teilen, die nicht von der Maske bedeckt sind, unter Verwendung eines Abziehmittels; und
einen Schritt zum Entfernen der Maske.

17. Dekorativer Gegenstand, der unter Verwendung eines Oberflächenbearbeitungsverfahrens für einen dekorativen Gegenstand nach einem der Ansprüche 1 bis 16 hergestellt wird.

18. Dekorativer Gegenstand, umfassend ein Basismaterial und einen Film, der mindestens einen Teil des Basismaterials bedeckt, wobei der Film aus einer Au-Pd-Fe-In-Legierung besteht, die 0,1 bis 10 Gewichtsprozent Pd, 0,1 bis 8 Gewichtsprozent Fe, 0,1 bis 10,0 Gewichtsprozent In und wahlweise einen Gesamtgehalt von 1,5 Gewichtsprozent oder weniger von einem oder mehreren von Cu, Zn, Ni, Mg, Cr, Mn, Mo, Nb, W, Al, Ag, V, Zr, Sn und Pt enthält, wobei der Rest der Legierung aus Au besteht.

19. Dekorativer Gegenstand nach Anspruch 18, des Weiteren umfassend mindestens eine primäre Beschichtung zwischen dem Basismaterial und dem Film.

20. Dekorativer Gegenstand nach Anspruch 19, wobei mindestens eine primäre Beschichtung eine Ausgleichsschicht zum Ausgleichen der möglichen Differenz zwischen ihrer einen Oberflächenseite und ihrer anderen Oberflächenseite ist.

21. Dekorativer Gegenstand nach Anspruch 19 oder 20, wobei mindestens eine primäre Beschichtung eine Metallnitridschicht ist, die aus einem Material besteht, das ein Nitrid von mindestens einem der Folgenden enthält: Ti, Zr, Hf, Ta, Cr.

22. Dekorativer Gegenstand nach einem der Ansprüche 19 bis 21, wobei mindestens eine primäre Beschichtung eine Metallschicht von oder eine Legierung bestehend aus mindestens einem der Folgenden ist: Cu, Co, Pd, Au, Ag, In, Sn, Ni, Ti, Zn, Al, Fe, Cr, Pt, Rh, Ru, Ir.

23. Dekorativer Gegenstand nach einem der Ansprüche 19 bis 22, wobei der Film eine Farbe nahe der Farbe IN-14 hat, wie im CEN-Standard EN 28654 definiert ist.

24. Dekorativer Gegenstand nach einem der Ansprüche 17 bis 23, wobei der dekorative Gegenstand ein Gehäuseteil für eine Uhr ist.

25. Uhr, umfassend einen dekorativen Gegenstand nach einem der Ansprüche 17 bis 24.

## Revendications

1. Procédé de traitement de surface pour un article décoratif, comprenant une étape pour former une pellicule se composant d'un alliage à base de Au-Pd-Fe-In contenant 0,1 à 10 % en poids de Pd, 0,1 à 8 % en poids de Fe, 0,1 à 10,0 % en poids d'In, et de manière optionnelle, une teneur totale de 1,5 % en poids ou moins d'un ou plusieurs parmi les suivants : Cu, Zn, Ni, Mg, Cr, Mn, Mo, Nb, W, Al, Ag, V, Zr, Sn et Pt, le reste de l'alliage étant formé par de l'Au, la pellicule étant formée grâce à un procédé de dépôt par voie sèche sur au moins une partie de la surface d'une matière de base.

2. Procédé de traitement de surface pour un article décoratif tel que revendiqué par la revendication 1, comprenant une autre étape pour appliquer un traitement de nettoyage à une partie au moins de la surface de la matière de base avant l'étape de formation de la pellicule.

3. Procédé de traitement de surface pour un article décoratif, comprenant une étape de formation d'un revêtement principal avec au moins une couche sur au moins une partie de la surface d'une matière de base, et
une étape de formation, sur ce revêtement principal, grâce à un procédé de dépôt par voie sèche, d'une pellicule se composant d'un alliage à base de Au-Pd-Fe-In contenant 0,1 à 10 % en poids de Pd, 0,1 à 8 % en poids de Fe, 0,1 à 10,0 % en poids d'In, et de manière optionnelle, une teneur totale de 1,5 % en poids ou moins d'un ou plusieurs parmi les suivants : Cu, Zn, Ni, Mg, Cr, Mn, Mo, Nb, W, Al, Ag, V, Zr, Sn et Pt, le reste de l'alliage étant formé par de l'Au.

4. Procédé de traitement de surface pour un article décoratif tel que revendiqué par la revendication 3, comprenant une autre étape pour appliquer un traitement de nettoyage à une partie au moins de la surface de la matière de base avant l'étape de formation du revêtement principal.

5. Procédé de traitement de surface pour un article décoratif tel que revendiqué par les revendications 3 ou 4, comprenant une autre étape pour appliquer un traitement de nettoyage à une partie au moins de la surface du revêtement principal avant le processus de formation d'une pellicule.

6. Procédé de traitement de surface pour un article décoratif tel que revendiqué par les revendications 3 à 5, au moins une couche du revêtement principal étant une couche tampon assurant un effet tampon pour la différence de potentiel entre un côté de surface de celle-ci et l'autre côté de surface.

7. Procédé de traitement de surface d'un article décoratif tel que revendiqué par l'une quelconque des revendications 3 à 6, au moins une couche du revêtement principal étant une couche de nitrure métallique se composant d'une matière contenant un nitrure de l'un au moins parmi les suivants : Ti, Zr, Hf, Ta, Cr.

8. Procédé de traitement de surface pour un article décoratif tel que revendiqué par la revendication 7, la couche de nitrure métallique entrant en contact avec la pellicule.

9. Procédé de traitement de surface pour un article décoratif tel que revendiqué par l'une quelconque des revendications 3 à 8, au moins une couche du revêtement principal étant une couche métallique d'un alliage se composant de l'un au moins parmi les suivants : Cu, Co, Pd, Au, Ag, In, Sn, Ni, Ti, Zn, Al, Fe, Cr, Pt, Rh, Ru, Ir.

10. Procédé de traitement de surface pour un article décoratif tel que revendiqué par l'une quelconque des revendications 3 à 9, l'article décoratif possédant deux ou davantage de revêtements principaux.

11. Procédé de traitement de surface pour un article décoratif tel que revendiqué par la revendication 1, des revêtements principaux adjacents se composants de matières contenant un élément commun.

12. Procédé de traitement de surface pour un article décoratif tel que revendiqué par l'une quelconque des revendications 1 à 11, la pellicule étant formée grâce à un procédé de métallisation sous vide.

13. Procédé de traitement de surface pour un article décoratif tel que revendiqué par la revendication 12, la pellicule étant formée grâce à un procédé de dépôt par voie sèche en utilisant plusieurs cibles de différentes compositions métalliques.

14. Procédé de traitement de surface pour un article décoratif tel que revendiqué par la revendication 13, une cible en alliage à base de Au-Pd-Fe et une cible d'In étant utilisées en tant que cibles.

15. Procédé de traitement de surface pour un article décoratif tel que revendiqué par l'une quelconque des revendications 1 à 14, la pellicule étant d'une couleur proche de la couleur IN-14 telle que définie par la norme CEN EN 28654.

16. Procédé de traitement de surface pour un article décoratif tel que revendiqué par l'une quelconque des revendications 1 à 15, comprenant par ailleurs une étape pour masquer au moins une partie de la surface de la pellicule après avoir formé la pellicule;
une étape pour enlever la pellicule sur des parties non recouvertes par le masque en utilisant un agent décapant ; et
une étape pour enlever le masque.

17. Article décoratif fabriqué en utilisant un procédé de traitement de surface pour un article décoratif tel que revendiqué par l'une quelconque des revendications 1 à 16.

18. Article décoratif comprenant une matière de base et une pellicule recouvrant au moins une partie de la matière de base, la pellicule se composant d'un alliage à base de Au-Pd-Fe-In contenant 0,1 à 10 % en poids de Pd, 0,1 à 8 % en poids de Fe, 0,1 à 10,0 % en poids d'In, et de manière optionnelle, une teneur totale de 1,5 % en poids ou moins de l'un ou plusieurs parmi les suivants : Cu, Zn, Ni, Mg, Cr, Mn, Mo, Nb, W, Al, Ag, V, Zr, Sn et Pt, le reste de l'alliage étant formé par de l'Au.

19. Article décoratif tel que revendiqué par la revendication 18, comprenant par ailleurs au moins un revêtement principal entre la matière de base et la pellicule.

20. Article décoratif tel que revendiqué par la revendication 19, au moins un revêtement principal étant une couche tampon pour assurer un effet tampon pour la différence de potentiel entre un côté de surface de celle-ci et l'autre côté de surface.

21. Article décoratif tel que revendiqué par les revendications 19 ou 20, au moins un revêtement principal étant une couche de nitrure métallique se composant d'une matière contenant un nitrure formé par l'un au moins des suivants : Ti, Zr, Hf, Ta, Cr.

22. Article décoratif tel que revendiqué par l'une quelconque des revendications 19 à 21, au moins un revêtement principal étant une couche métallique d'un alliage se composant de l'un au moins parmi les suivants : Cu, Co, Pd, Au, Ag, In, Sn, Ni, Ti, Zn, Al, Fe, Cr, Pt, Rh, Ru, Ir.

23. Article décoratif tel que revendiqué par l'une quelconque des revendications 19 à 22, la pellicule présentant une couleur proche de la couleur 1N-14 telle que définie par la norme CEN EN 28654.

24. Article décoratif tel que revendiqué par l'une quelconque des revendications 17 à 23, l'article décoratif étant un élément de boîtier pour un article d'horlogerie.

25. Article d'horlogerie comprenant un article décoratif tel que revendiqué par l'une quelconque des revendications 17 à 24.
